# EUROPEAN PATENT APPLICATION

(11) **EP 2 312 560 A1**
(43) Date of publication of application: **20.04.2011**
(21) Application number: 09800361.9
(22) Date of filing: 16.07.2009
(51) Int. Cl.: G09F 9/30, G02F 1/1368, H01L 21/28, H01L 21/3205, H01L 21/336, H01L 23/52, H01L 29/417, H01L 29/423, H01L 29/49, H01L 29/786, H01L 51/50, H05B 33/02, H05B 33/12, H05B 33/26

(54) **ACTIVE MATRIX SUBSTRATE, DISPLAY PANEL, DISPLAY DEVICE, AND ACTIVE MATRIX SUBSTRATE MANUFACTURING METHOD**

(30) Priority: 25.07.2008 JP 2008192608
(71) Applicant: Sumitomo Chemical Company, Limited, Tokyo 104-8260 (JP)
(72) Inventor: MATSUMURO, Tomonori, Tsukuba-shi Ibaraki 305-0051 (JP); FUKUHARA, Noboru, Tsukuba-shi Ibaraki 305-0035 (JP); HASEGAWA, Akira, Tsukuba-shi Ibaraki 305-0821 (JP)
(74) Representative: Jackson, Martin Peter
(86) International application number: PCT/JP2009/062923
(87) International publication number: WO 2010/010847

(57) **Abstract**

An active matrix substrate (101A) comprises a transparent substrate (10), a wiring formed on the transparent substrate (such as L_{G}, L_{D}, L_{P}, L1, and L2), a transparent semiconductor layer (44) that covers at least a part of the wiring, and a transparent insulating film that covers at least a part of the wiring and of the transparent semiconductor layer. The wiring comprises a first metal wiring (41M) serving as a main wiring and a transparent wiring (such as 41, 42, and 43) that branches from the main wiring and serves as a sub-wiring. At least a part of the first metal wiring serving as the main wiring is formed by using a material that has a higher conductivity than that of a material for a wiring serving as the sub-wiring.

## Description

### TECHNICAL FIELD

The present invention relates to an active matrix substrate, a display panel, a display device, and a method for manufacturing the active matrix substrate, and more particularly relates to an active matrix substrate comprising a transistor element, particularly a thin film transistor (TFT) element, a display panel, a display device, and a method for manufacturing an active matrix substrate.

### BACKGROUND ART

In recent years, flat panel display (FPD) devices represented by liquid-crystal display (LCD) devices and organic EL (Electroluminescent) display devices have been developed intensively, because these devices are capable of achieving reduced consumption power, low drive voltage, and space savings.

In an FPD device, a driving method for a liquid-crystal display device and an organic EL display device is roughly classified into two methods, that is; a static driving method and a dynamic driving method. An active matrix driving method classified as the dynamic driving method has attracted attention because it can reduce crosstalk between pixels and reproduce images more clearly.

At the time of realizing the active matrix driving method, a circuit substrate that is a so-called array substrate comprising one or more switching elements and capacitive elements for each pixel is generally used. Such a substrate is called active matrix substrate in this specification.

For example, in a case of a liquid-crystal display device, a liquid crystal element is provided between an active matrix substrate and an opposing substrate. Light generated by a light source in the device is viewed through the active matrix substrate, the liquid crystal element, and the opposing substrate. At this time, a voltage is applied as appropriate to the liquid crystal element for controlling a molecular arrangement thereof, so that a color tone and a gradation of images are represented.

Further, in a case of an organic EL display device, an organic-light emitting diode is provided on one main surface side of the active matrix substrate for each pixel. Light from the organic-light emitting diode is viewed through the active matrix substrate (a bottom emission type) or not through the active matrix substrate (a top emission type). At this time, by controlling the amount of current flowing in the organic-light emitting diode, the color tone and the gradation of images are represented.

Due to the above configurations, the active matrix substrate is an important factor for determining the thickness of a panel in the FPD such as a liquid-crystal display device or an organic EL display device. A transistor element, particularly a thin film element such as a TFT element, is generally used for a switching element of the active matrix substrate in view of slimming down of a panel part.

Because electrode materials, semiconductor materials, and insulating films have been developed, a transparent TFT can be formed (see, for example, Nonpatent literature 1 mentioned below).

### PRIOR ART DOCUMENTS

### NONPATENT LITERATURE

Nonpatent literature 1: Toshio KAMIYA, et al., "Designing of amorphous oxide semiconductors and roomtemperature fabrication of high-performance flexible thin-film transistors", Transactions of the 19th Advanced Technology Award, [online], [searched on April, 9, 2008], Internet <URL:http://www.fbi-
award.jp/sentan/jusyou/2005/toko_canon.pdf>

### DISCLOSURE OF INVENTION

### PROBLEM TO BE SOLVED BY THE INVENTION

An aperture ratio of an active matrix substrate is one of factors for determining a performance of a liquid-crystal display device and an organic EL display device. This aperture ratio is an important factor for realizing higher density, higher contrast ratio, and higher brightness. As the aperture ratio is increased, high integration, high contrast ratio, and high brightness can be realized.

However, while a transistor element in the active matrix substrate can be made transparent by the conventional techniques described above, wiring parts cannot be made transparent by these conventional techniques. A large cross-sectional area is required for wirings to reduce the consumption power and drive voltage of a liquid-crystal display device and an organic EL display device. Therefore, lack of transparency of the wirings restricts an improvement in the aperture ratio of conventional active matrix substrates.

Formerly, Indium Tin Oxide (ITO) was generally used as a transparent electrode material, and the specific resistance thereof is greater than that is metals serving as conductor. Therefore, in the case of forming all wirings by using a transparent electrode material, drive voltage of active matrix substrate is increased. As a result, a problem of increasing the consumption power may occur

Therefore, the present invention has been achieved in view of the above problems, and an object of the invention is to provide an active matrix substrate capable of improving an aperture ratio and reducing consumption power, a display panel, a display device, and a method for manufacturing an active matrix substrate.

### MEANS FOR SOLVING PROBLEM

For achieving the above object, the present invention provides the following:
[1] An active matrix substrate having a plurality of transistor elements, the active matrix substrate comprising:
   a substrate that can transmit visible light;
   a wiring that comprises a main wiring formed on the substrate and a sub-wiring that is formed on the substrate and connects the main wiring to the transistor element;
   a semiconductor layer that overlaps at least a part of the wiring in a thickness direction of the substrate and can transmit visible light; and
   an insulating film that covers at least a part of the wiring and of the semiconductor layer and can transmit visible light, wherein
   the sub-wiring is made of a conductive material that can transmit visible light, and
   the main wiring is made of a conductive material at least a part of which has a higher conductivity than that of the sub-wiring.
[2] The active matrix substrate according to above [1], wherein the semiconductor layer is made of a semiconductor material whose main ingredient is same as a main ingredient of a conductive material of the sub-wiring.
[3] The active matrix substrate according to above [1] or [2], wherein a main ingredient of a conductive material for the sub-wiring and a semiconductor material for the semiconductor layer is an inorganic oxide.
[4] The active matrix substrate according to any one of above [1] to [3], wherein
   the sub-wiring is made of a conductive material made of zinc tin oxide, and
   the semiconductor layer is made of a semiconductor material whose carrier density is lower than that of the sub-wiring and that is made of zinc tin oxide.
[5] The active matrix substrate according to any one of above [1] to [4], wherein at least a part of the main wiring is made of metal or alloy.
[6] The active matrix substrate according to any one of above [1] to [5], wherein a part of the sub-wiring functions as an electrode in the transistor element.
[7] The active matrix substrate according to any one of above [1] to [6], wherein a part of the sub-wiring functions as a gate electrode, a source electrode, and a drain electrode in the transistor element, and a part of the insulating film functions as a gate insulating film in the transistor element.
[8] The active matrix substrate according to any one of above [1] to [7], comprising a first transistor, a second transistor, and a capacitor, wherein
   the main wiring constitutes at least a part of one or more scanning lines, at least a part of one or more data lines, and at least a part of one or more drive lines,
   a control terminal of the first transistor is connected to the scanning line and an input terminal thereof is connected to the data line,
   a control terminal of the second transistor is connected to an output terminal of the first transistor and an input terminal of the second transistor is connected to the drive line, and
   one electrode of the capacitor is connected to the drive line and the other terminal of the capacitor is connected to the control terminal of the second transistor.
[9] The active matrix substrate according to any one of above [1] to [7], comprising a first transistor and a capacitor, wherein
   the main wiring constitutes at least a part of one or more scanning lines, at least a part of one or more data lines, and at least a part of one or more capacitance lines,
   a control terminal of the first transistor is connected to the scanning line and an input terminal of the first transistor is connected to the data line, and
   one terminal of the capacitor is connected to an output terminal of the transistor.
[10] A display panel comprising:
   the active matrix substrate according to any one of above [1] to [8];
   a first electrode that is formed on the active matrix substrate and can transmit visible light;
   an organic film formed on the first electrode; and
   a second electrode formed on the organic film.
[11] The display panel according to above [10], wherein the second electrode can transmit visible light.
[12] The display panel according to above [11], comprising an auxiliary electrode that is electrically connected to the second electrode.
[13] The display panel according to above [12], wherein the auxiliary electrode can transmit visible light.
[14] The display panel according to any one of above [10] to [13], comprising a filter film that is formed on one or both of an upper layer and a lower layer with respect to the organic film.
[15] A display panel comprising:
   the active matrix substrate according to any one of above [1] to [7] and [9];
   an opposing substrate that can transmit visible light; and
   a liquid crystal element that comprises a liquid crystal layer, two alignment films that sandwich the liquid crystal layer, and a pixel electrode and a common electrode that sandwich a laminated body comprising the liquid crystal layer and the two alignment films, wherein
   the pixel electrode and the common electrode can transmit visible light,
   the pixel electrode is electrically connected to the wiring in the active matrix substrate, and
   the liquid crystal element is sandwiched between the active matrix substrate and the opposing substrate.
[16] The display panel according to above [15], comprising two polarizing plates that sandwich a laminated body that comprises the active matrix substrate, the liquid crystal element, and the opposing substrate.
[17] The display panel according to above [15] or [16], comprising:
   a light shielding film that is formed on the common electrode; and
   a filter film that is formed at least on the common electrode and transmits a wavelength of a predetermined band.
[18] A display device comprising the display panel according to any one of above [10] to [17].
[19] A method for manufacturing an active matrix substrate comprising:
   forming, on the substrate, a main wiring that can transmit visible light;
   forming, on the substrate, a first sub-wiring that is electrically connected to the main wiring, a part of which comprises an electrode that forms a transistor element, and that can transmit visible light;
   forming, on the substrate, a first insulating film that covers at least a part of the main wiring and of the first sub-wiring, a part of which comprises an insulating film that forms the transistor element, and that can transmit visible light;
   forming, on the first insulating film, a second sub-wiring a part of which comprises an electrode that forms the transistor element and that can transmit visible light;
   forming, on the first insulating film, a semiconductor layer that covers at least a part of the second sub-wiring and can transmit visible light; and
   forming, on the first insulating film, a second insulating film that covers at least a part of the semiconductor layer and of the second sub-wiring and can transmit visible light, wherein
   at least a part of the main wiring is made of a material with a higher conductivity than that of the first and/or second sub-wiring.
[20] The method for manufacturing an active matrix substrate according to above [19], wherein the semiconductor layer is formed by using a semiconductor material whose main ingredient is same as that of the second sub-wiring.
[21] The method for manufacturing an active matrix substrate according to above [19] or [20], wherein a main ingredient of a conductive material for the second sub-wiring and a semiconductor material for the semiconductor layer is an inorganic oxide.
[22] The method for manufacturing an active matrix substrate according to any one of above [19] to [21], wherein
   the second sub-wiring is formed by using a conductive material made of zinc tin oxide, and
   the semiconductor layer is formed by using a semiconductor material made of zinc tin oxide whose carrier density can be lower than that of the second sub-wiring.
[23] The method for manufacturing an active matrix substrate according to any one above [19] to [22], wherein at least a part of the main wiring is formed by using metal or alloy.
[24] The method for manufacturing an active matrix substrate according to any one of above [19] to [23], wherein at the step of forming the semiconductor layer, a semiconductor film that covers the second sub-wiring is formed on the first insulating film and etched such that the second sub-wiring is not exposed, so that the semiconductor layer is formed.
[25] The method for manufacturing an active matrix substrate according to any one of above [19] to [24], wherein at at least one of the step of forming the first wiring, forming the first insulating film, forming the second wiring, forming the semiconductor layer, and forming the second insulating film, the main wiring, the first sub-wiring, the first insulating film, the second sub-wiring, the semiconductor layer, or the second insulating film is formed by printing method or ink jet printing method.

### EFFECT OF THE INVENTION

According to the present invention, at least a part of the element and a part of the wiring are transparent with respect to visible light, and thus the active matrix substrate having an improved aperture ratio can be realized. In addition, according to the present invention, at least a part of the main wiring is made of a material that has a conductivity higher than that of the sub-wiring, and thus, according to the present invention, a active matrix substrate capable of improving an aperture ratio and reducing consumption power can be realized. Because of the same reason, according to the present invention, the active matrix substrate with a remarkably improved aperture ratio and reduced consumption power can be manufactured. By using such an active matrix substrate according to the present invention, the display panel and the display device with a remarkably improved aperture ratio and reduced consumption power can be realized.

### BRIEF DESCRIPTION OF DRAWINGS

[Fig. 1] Fig. 1 is a block diagram of a schematic configuration of an organic EL display device according to a first embodiment of the present invention.
[Fig. 2] Fig. 2 is a schematic diagram of a schematic circuit configuration of respective pixels according to the first embodiment of the present invention.
[Fig. 3] Fig. 3 is a schematic plan view for explaining a layout structure of an active matrix substrate in respective pixels according to the first embodiment of the present invention.
[Fig. 4] Fig. 4 is a schematic cross-sectional view for explaining a layer structure of respective pixels according to the first embodiment of the present invention.
[Fig. 5-1] Fig. 5-1 is a process cross-sectional view of a method for manufacturing a display panel of the organic EL display device according to the first embodiment of the present invention (part 1).
[Fig. 5-2] Fig. 5-2 is a process cross-sectional view of the method for manufacturing the display panel of the organic EL display device according to the first embodiment of the present invention (part 2).
[Fig. 5-3] Fig. 5-3 is a process cross-sectional view of the method for manufacturing the display panel of the organic EL display device according to the first embodiment of the present invention (part 3).
[Fig. 5-4] Fig. 5-4 is a process cross-sectional view of the method for manufacturing the display panel of the organic EL display device according to the first embodiment of the present invention (part 4).
[Fig. 5-5] Fig. 5-5 is a process cross-sectional view of the method for manufacturing the display panel of the organic EL display device according to the first embodiment of the present invention (part 5).

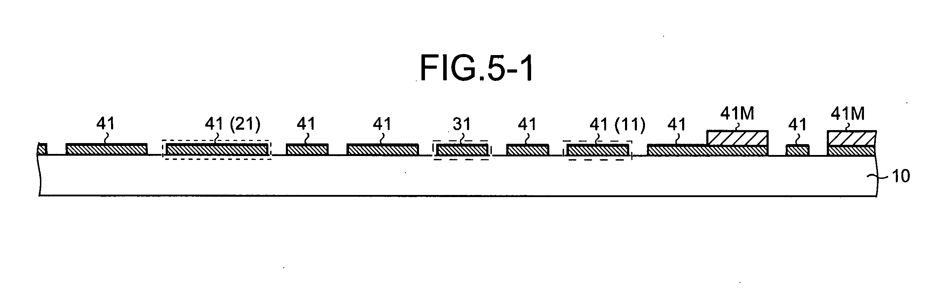

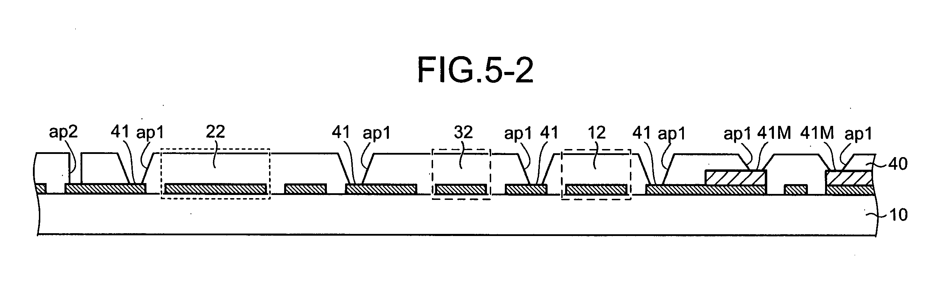

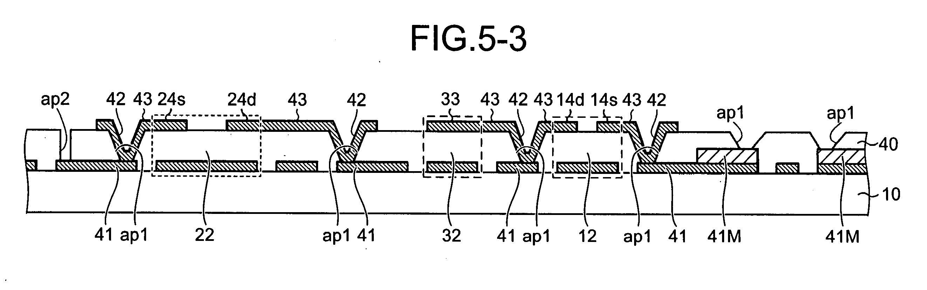

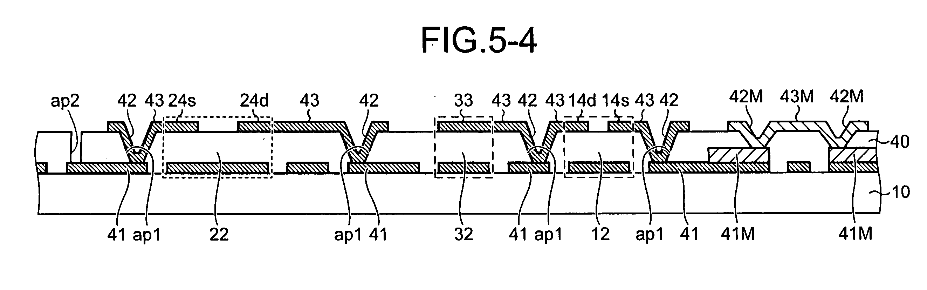

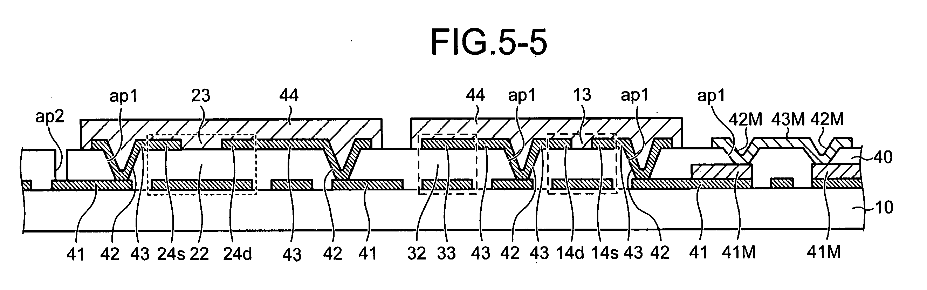

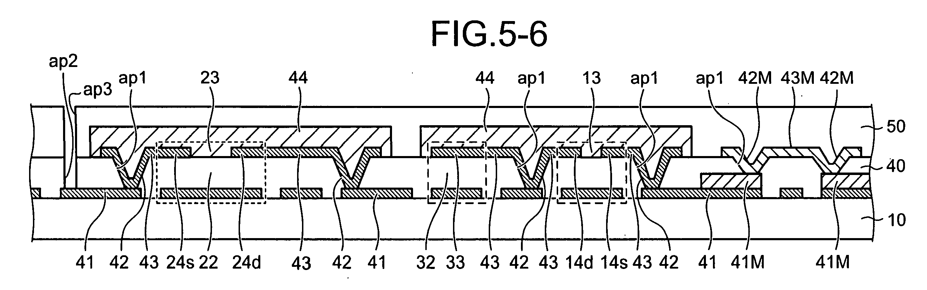

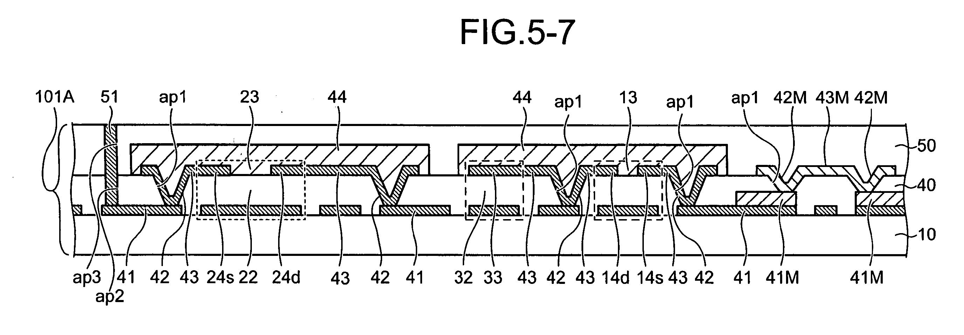

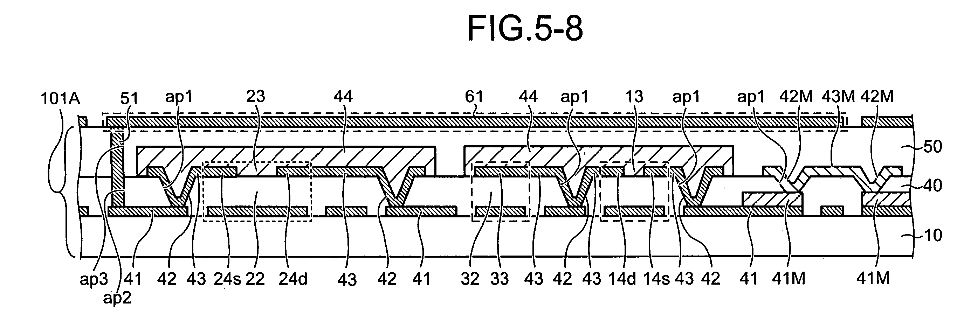

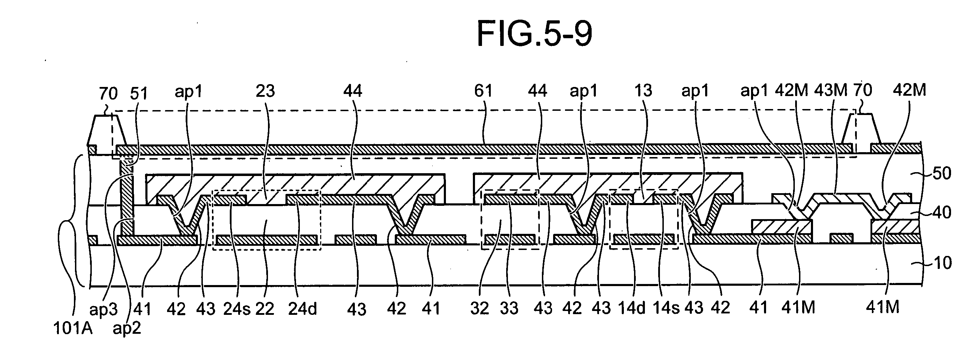

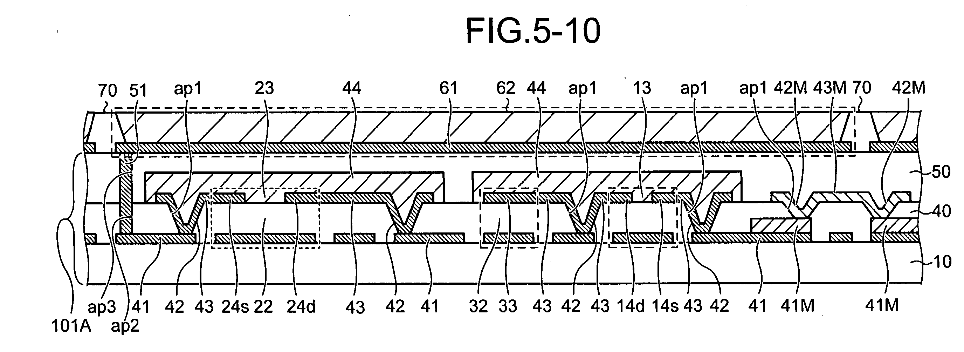

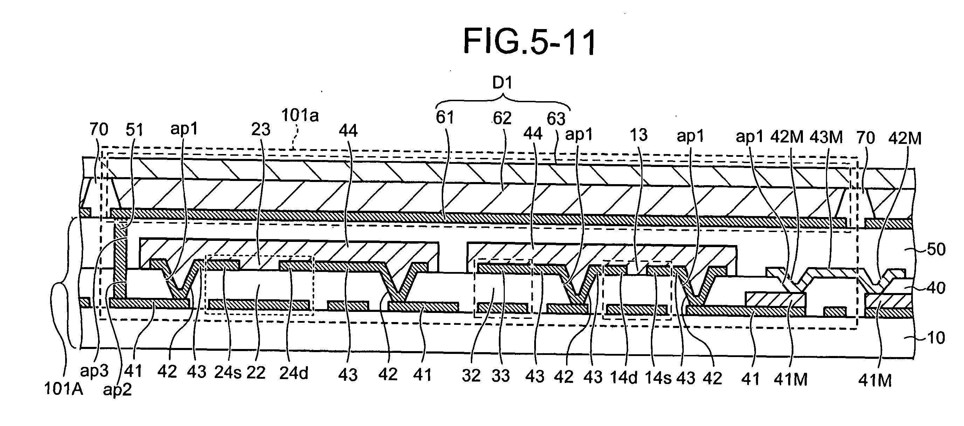

[Fig. 5-6] Fig. 5-6 is a process cross-sectional view of the method for manufacturing the display panel of the organic EL display device according to the first embodiment of the present invention (part 6).
[Fig. 5-7] Fig. 5-7 is a process cross-sectional view of the method for manufacturing the display panel of the organic EL display device according to the first embodiment of the present invention (part 7).
[Fig. 5-8] Fig. 5-8 is a process cross-sectional view of the method for manufacturing the display panel of the organic EL display device according to the first embodiment of the present invention (part 8).
[Fig. 5-9] Fig. 5-9 is a process cross-sectional view of the method for manufacturing the display panel of the organic EL display device according to the first embodiment of the present invention (part 9).
[Fig. 5-10] Fig. 5-10 is a process cross-sectional view of the method for manufacturing the display panel of the organic EL display device according to the first embodiment of the present invention (part 10).
[Fig. 5-11] Fig. 5-11 is a process cross-sectional view of the method for manufacturing the display panel of the organic EL display device according to the first embodiment of the present invention (part 11).

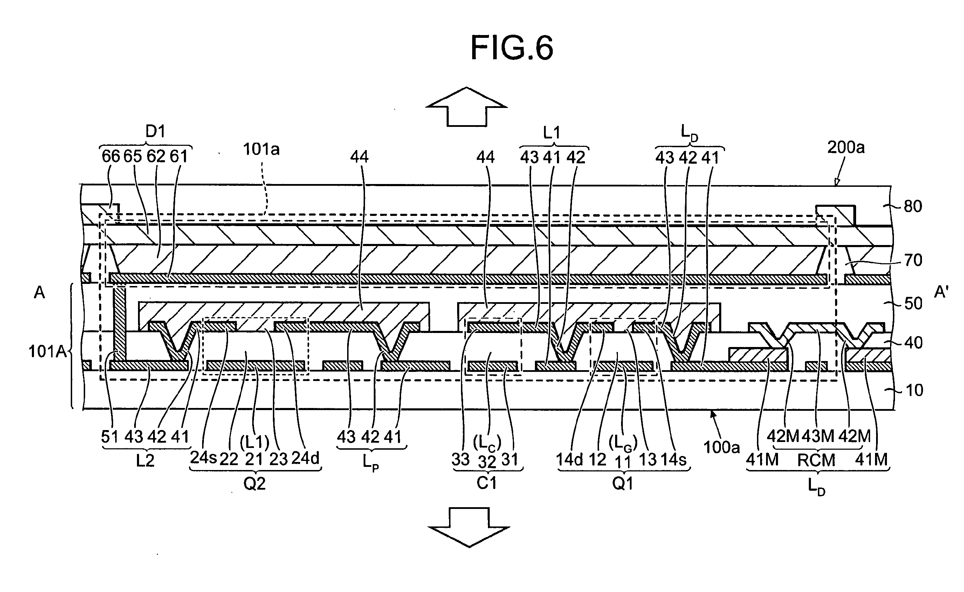

[Fig. 6] Fig. 6 is a schematic cross-sectional view for explaining a layer structure of respective pixels according to a second embodiment of the present invention.

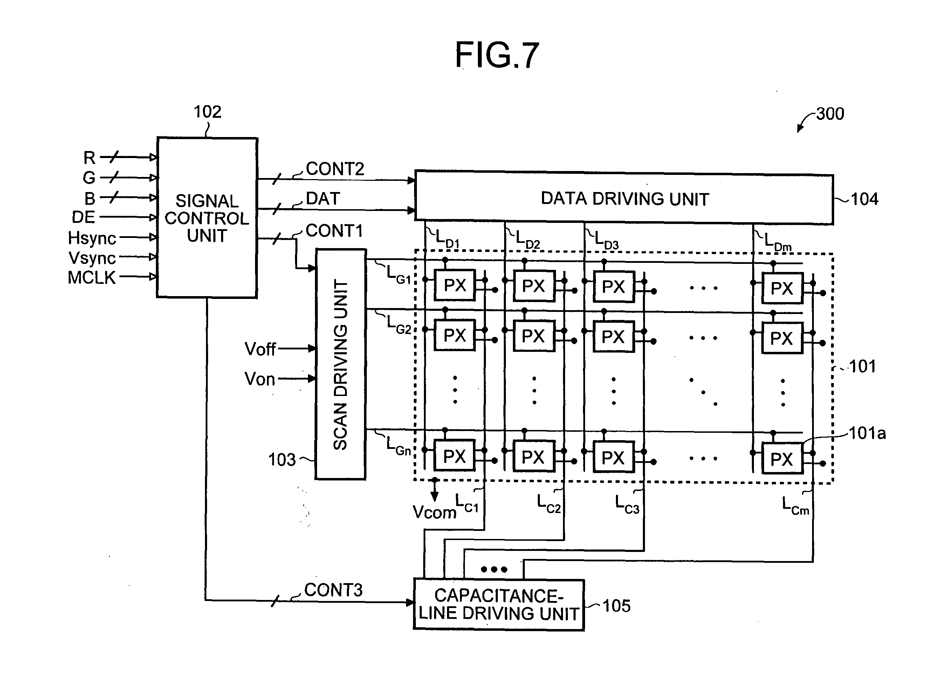

[Fig. 7] Fig. 7 is a block diagram of a schematic configuration of a liquid-crystal display device according to a third embodiment of the present invention.

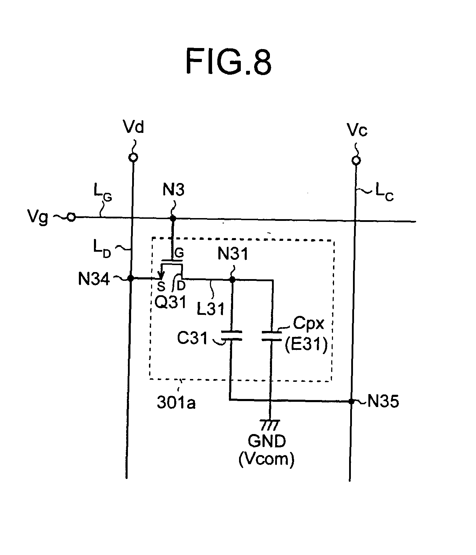

[Fig. 8] Fig. 8 is a schematic diagram of a schematic circuit configuration of respective pixels according to the third embodiment of the present invention.

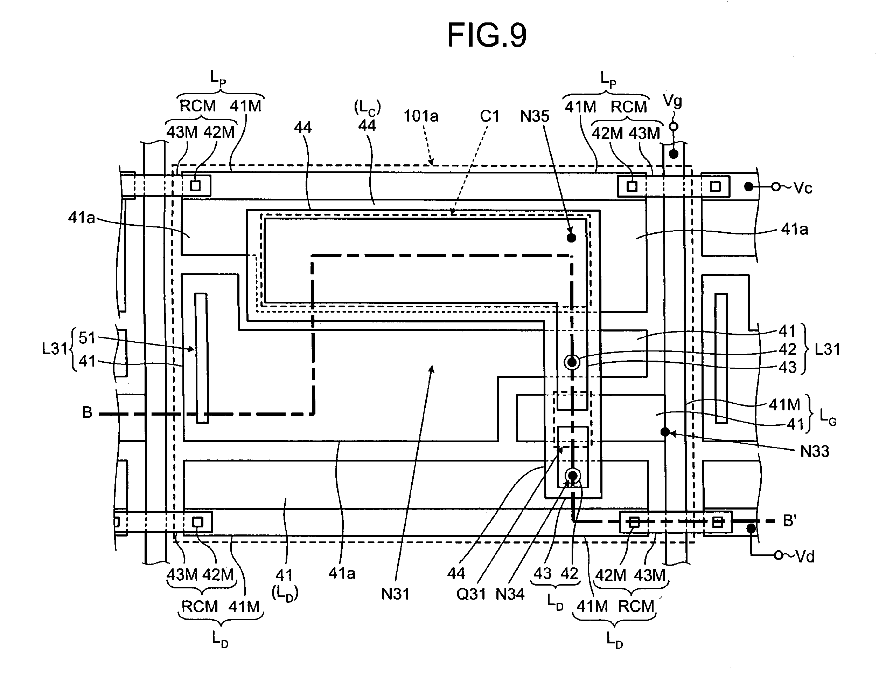

[Fig. 9] Fig. 9 is a schematic plan view for explaining a layout structure of an active matrix substrate in respective pixels according to the third embodiment of the present invention.

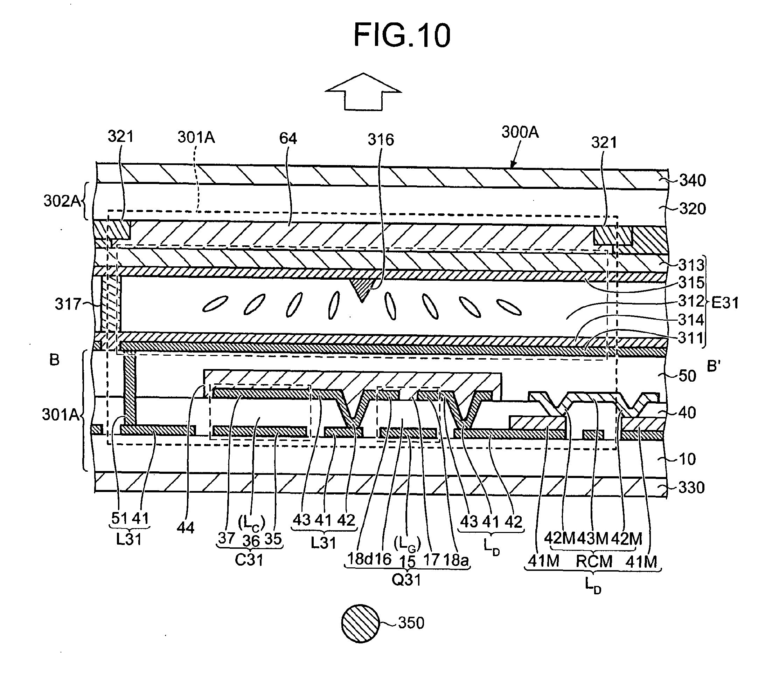

[Fig. 10] Fig. 10 is a schematic cross-sectional view for explaining a layer structure of respective pixels according to the third embodiment of the present invention.

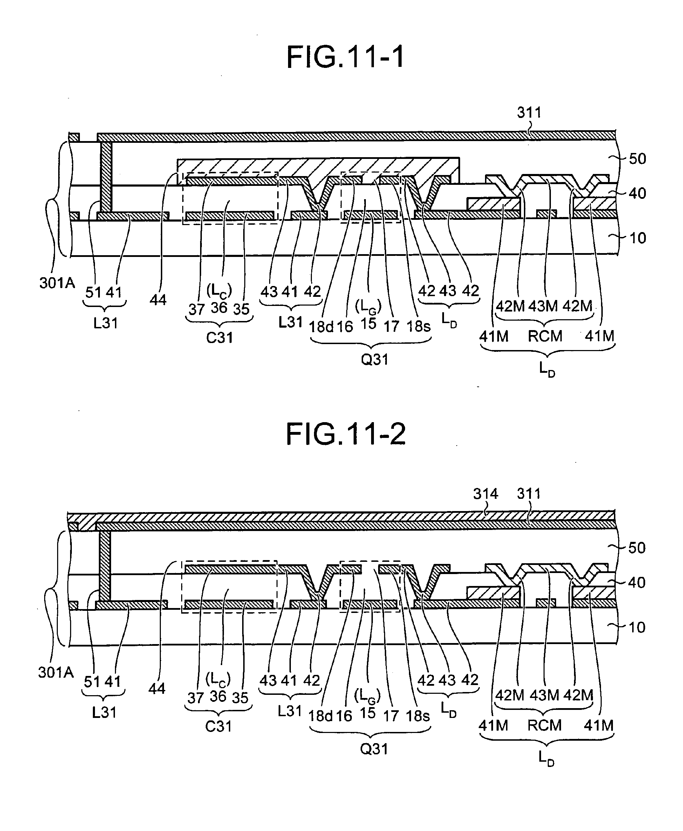

[Fig. 11-1] Fig. 11-1 is a process cross-sectional view of a method for manufacturing a display panel of the liquid-crystal display device according to the third embodiment of the present invention (part 1).
[Fig. 11-2] Fig. 11-2 is a process cross-sectional view of the method for manufacturing the display panel of the liquid-crystal display device according to the third embodiment of the present invention (part 2).

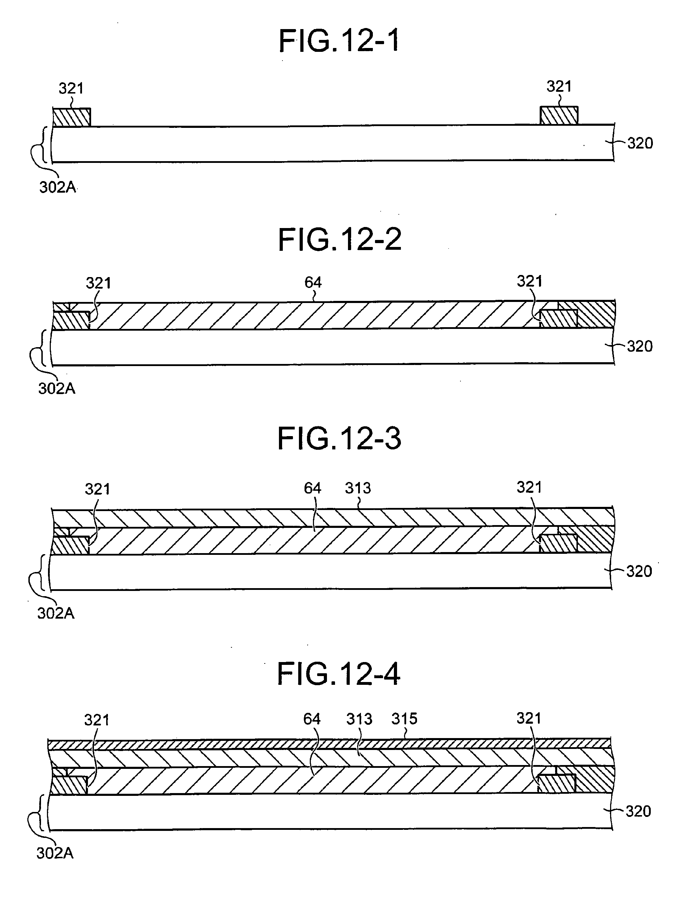

[Fig. 12-1] Fig. 12-1 is a process cross-sectional view of the method for manufacturing the display panel of the liquid-crystal display device according to the third embodiment of the present invention (part 3).
[Fig. 12-2] Fig. 12-2 is a process cross-sectional view of the method for manufacturing the display panel of the liquid-crystal display device according to the third embodiment of the present invention (part 4).
[Fig. 12-3] Fig. 12-3 is a process cross-sectional view of the method for manufacturing the display panel of the liquid-crystal display device according to the third embodiment of the present invention (part 5).
[Fig. 12-4] Fig. 12-4 is a process cross-sectional view of the method for manufacturing the display panel of the liquid-crystal display device according to the third embodiment of the present invention (part 6).

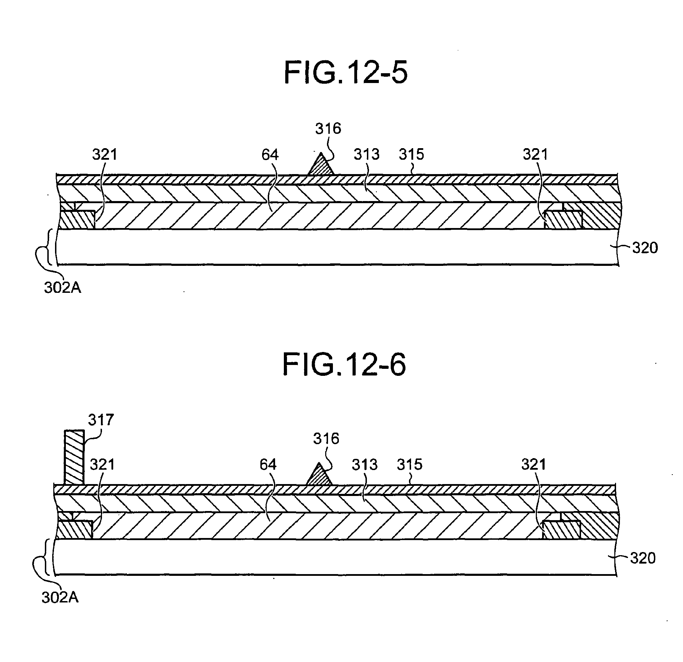

[Fig. 12-5] Fig. 12-5 is a process cross-sectional view of the method for manufacturing the display panel of the liquid-crystal display device according to the third embodiment of the present invention (part 7).
[Fig. 12-6] Fig. 12-6 is a process cross-sectional view of the method for manufacturing the display panel of the liquid-crystal display device according to the third embodiment of the present invention (part 8).

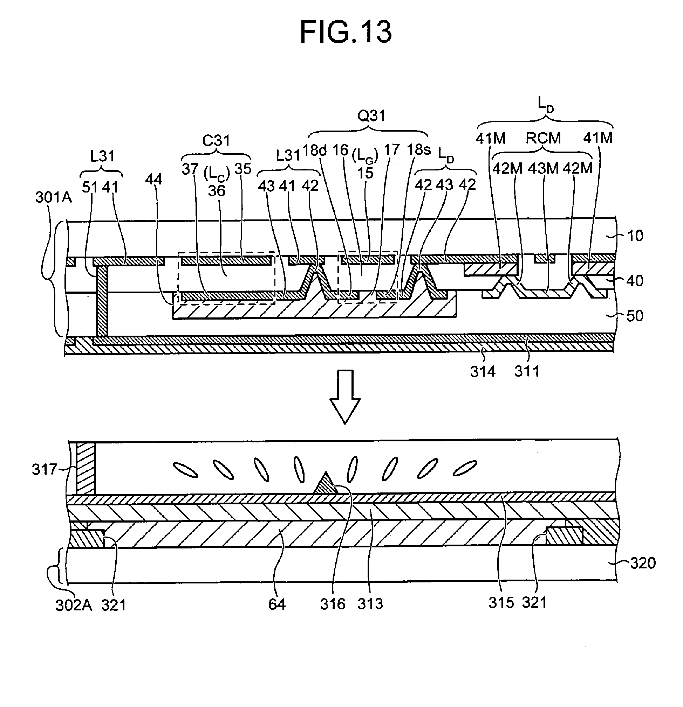

[Fig. 13] Fig. 13 is a process cross-sectional view of the method for manufacturing the display panel of the liquid-crystal display device according to the third embodiment of the present invention (part 9).

### BEST MODE(S) FOR CARRYING OUT THE INVENTION

Exemplary embodiments of the present invention will be explained below in detail with reference to the accompanying drawings. The present invention is not limited to the embodiments. Further, in the following explanations, the drawings merely schematically depict the shape, size, and positional relationships to an extent that the content of the present invention can be understood. Therefore, the present invention is not limited only to the shape, size, and positional relationships exemplified in the respective drawings. In addition, for simplifying configurations, a part of hatchings of cross-sections will be omitted. Numerical values to be exemplified below are merely preferred examples of the present invention, and thus the present invention is not limited to the numerical values exemplified below.

### <First embodiment>

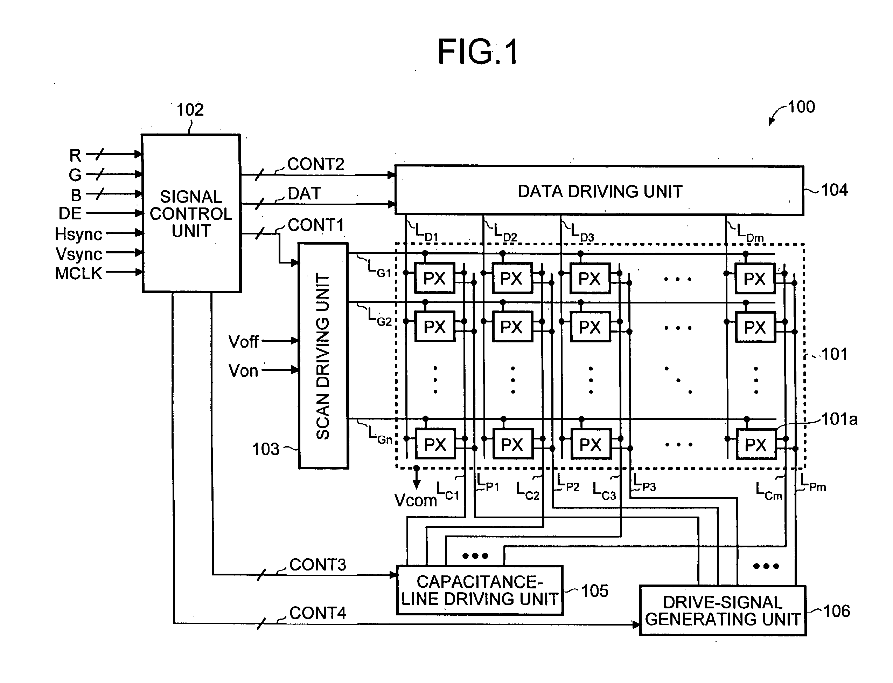

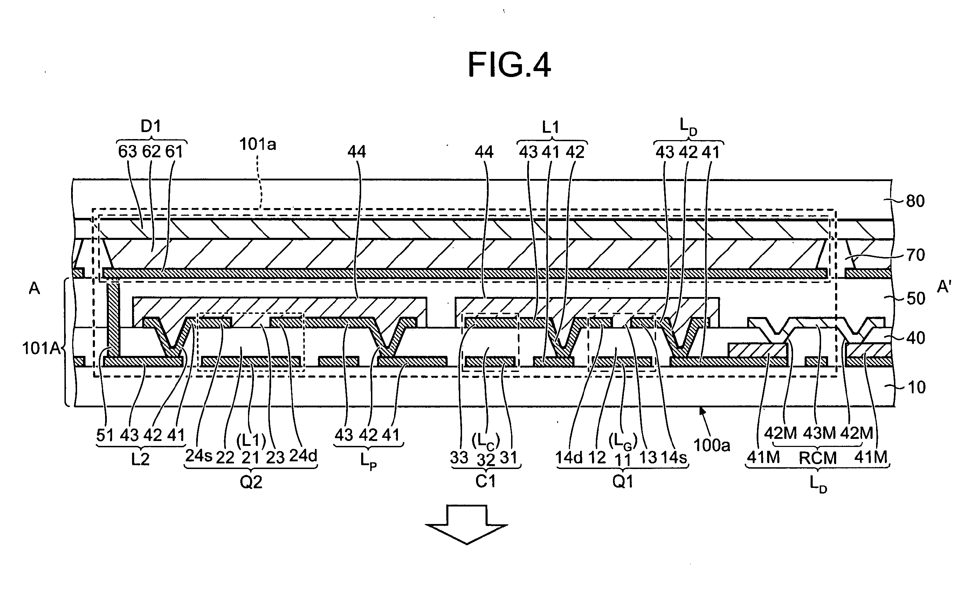

An organic EL display device 100 is described first as a display device according to the first embodiment of the present invention. Fig. 1 is a block diagram of a schematic configuration of the organic EL display device 100. The present embodiment describes the organic EL display device 100 of a bottom emission type, that is, a device that can output light from a light emitting element (for example, an organic-light emitting diode D1 in Fig. 4) through an element substrate (for example, an active matrix substrate 101A in Fig. 4) to outside from its bottom surface (for example, a bottom surface 100a in Fig. 4).

### (Overall Configuration)

As shown in Fig. 1, the organic EL display device 100 comprises a display panel 101 that comprises pixels (PX) 101a arranged in a two-dimensional matrix, a scan driving unit 103, a data driving unit 104, a capacitance-line driving unit 105, and a drive-signal generating unit 106 that are connected to the display panel, and a signal control unit 102 that controls these units. The display panel 101 comprises the pixels 101a for three primary colors, that is, red (R), green (G), and blue (B), respectively.

The display panel 101 comprises scanning lines L_{G1}, L_{G2}, ..., L_{Gn} that are connected to the scan driving unit 103 and transmit scanning signals (hereinafter, any scanning line is indicated by L_{G}), data lines L_{D1}, L_{D2}, L_{D3}, ..., L_{Dm} that are connected to the data driving unit 104 and transmit data signals (hereinafter, any data line is indicated by L_{D}), capacitance lines L_{C1}, L_{C2}, L_{C3}, ..., L_{Cm} that are connected to the capacitance-line driving unit 105 and transmit capacitance line drive signals (hereinafter, any capacitance line is indicated by L_{C}), and drive lines L_{P1}, L_{P2}, L_{P3}, ..., L_{Pm} that are connected to the drive-signal generating unit 106 and transmit drive signals (hereinafter, any drive line is indicated by L_{P}).

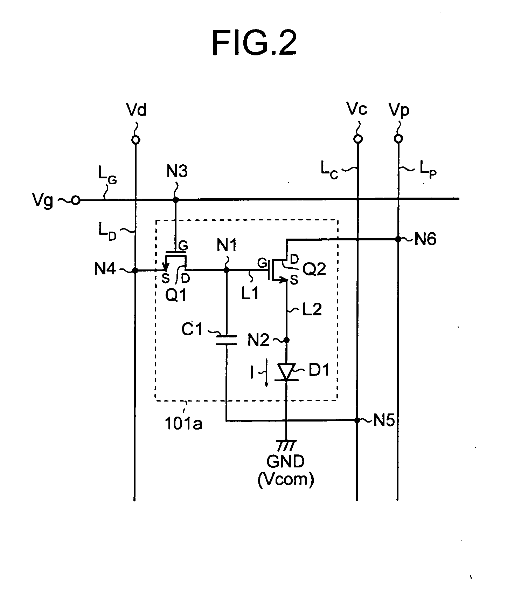

The scanning lines L_{G1} to L_{Gn} extend in a substantially row direction and the data lines L_{D1} to L_{Dm} extend in a substantially column direction in Fig. 1. The scanning lines L_{G1} to L_{Gn} thus intersect the data lines L_{D1} to L_{Dm} in a two-dimensional matrix. Each of the pixels 101a is arranged at an intersection in the two-dimensional matrix and connected to corresponding scanning line L_{G} and data line L_{D}. The capacitance lines L_{C1} to L_{Cm} extend in substantially parallel to the data lines L_{D1} to L_{Dm} and are connected to the pixels 101a arranged at their intersections. Similarly, the drive lines L_{P1} to L_{Pm} extend in substantially parallel to the data lines L_{D1} to L_{Dm} and are connected to the pixels 101a arranged at their intersections. According to the present embodiment, in the scanning line L_{G}, the data line L_{D}, the capacitance line L_{C}, and the drive line L_{P}, a part of a wiring that extends in the row or column direction so as to intersect with other lines is called main wiring and a part of a wiring that branches from the main wiring to be connected to an element such as a switching transistor Q1, a driving transistor Q2, or a capacitor C1 in the pixel 101a (see Fig. 2, for example) is called sub-wiring. A wiring that connects the elements (such as L1 and L2) is also called sub-wiring.

The signal control unit 102 generates a scanning control signal CONT1, a data control signal CONT2, a capacitance line control signal CONT3, a light emission control signal CONT4, and a video data signal DAT, which are for controlling reproduction of images, based on eternally inputted video signals R, G, B and input control signals for controlling a display of the video signals (a data enable signal DE, a horizontal synchronizing signal Hsync, a vertical synchronizing signal Vsync, and a main clock MCLK).

The generated scanning control signal CONT1 is inputted to the scan driving unit 103. The scanning control signal CONT1 comprises a vertical synchronization start signal that instructs the start of an output of a gate on voltage Von to be described later, a gate clock signal that controls a timing of outputting the gate on voltage Von, and an output enable signal that controls a period that the gate on voltage Von is outputted. The gate on voltage Von and a gate off voltage Voff for switching on/off the switching transistor Q1 comprised in each of the pixels 101a (see Fig. 2) are also inputted to the scan driving unit 103. The scan driving unit 103 generates the scanning signal by using the gate on voltage Von and the gate off voltage Voff according to the scanning control signal CONT1 and inputs the resultant scanning signal to the scanning line L_{G}.

The data control signal CONT2 and the video data signal DAT are inputted to the data driving unit 104. The data control signal CONT2 comprises a horizontal synchronizing start signal that instructs the start of inputting the video data signal DAT and a load signal for inputting the data signal to the data line L_{D}. The data driving unit 104 latches the received video data signal DAT according to the data control signal CONT2, and then generates as appropriate the data signal corresponding to the video data signal DAT and inputs a resultant data signal to the data line L_{D}.

The capacitance line control signal CONT3 is inputted to the capacitance-line driving unit 105. The capacitance line control signal CONT3 generates the capacitance line drive signal for driving the capacitance line L_{C}. The capacitance-line driving unit 105 generates the capacitance line drive signal for driving the capacitance line L_{C} according to the capacitance line control signal CONT3 and inputs a resultant signal to the capacitance line L_{C}.

The light emission control signal CONT4 is inputted to the drive-signal generating unit 106. The light emission control signal CONT4 generates the drive signal for driving the organic-light emitting diode D1 (see Fig. 2). The drive-signal generating unit 106 generates the drive signal that makes the organic-light emitting diode D1 emit or not emit light according to the light emission control signal CONT4 and inputs a resultant signal to the drive line L_{P}.

The drive signal is inputted to an anode of the organic-light emitting diode D1 to be described later. A common voltage Vcom is inputted to a cathode of the organic-light emitting diode D1 (see Fig. 2). According to the present embodiment, a voltage level of the drive signal during a period that the organic-light emitting diode D1 emits light is higher than that of the common voltage Vcom and the voltage level of the drive signal during a period other than this period is equal to or lower than that of the common voltage Vcom, so that light emission/non-light emission of the organic-light emitting diode D1 is controlled. The common voltage Vcom can be, for example, a ground potential. A power source line can be used instead of the drive line L_{P}. In this case, the drive-signal generating unit 106 is omitted and a supply voltage is applied to the power source line.

### (Pixel Configuration)

A schematic configuration and an operation of each of the pixels 101a are described with reference to Fig. 2. The following descriptions are applied to any of R, G, and B pixels 101a.

Fig. 2 is a schematic diagram of a schematic circuit configuration of the pixel 101a. As shown in Fig. 2, the pixel 101a comprises the switching transistor Q1, the driving transistor Q2, the capacitor C1, and the organic-light emitting diode D1.

The switching transistor Q1 is, for example, an n-type TFT and its source S is connected to a sub-wiring branched from the main wiring of the data line L_{D} at, for example, a node N4 and its drain D is connected through a wiring L1 that comprises a node N1 to a gate G of the driving transistor Q2. A gate G of the switching transistor Q1 is connected to a sub-wiring branched from the main wiring of the scanning line L_{G} at, for example, a node N3. The switching transistor Q1 conducts or disconnects between the data line L_{D} and the node N1 depending on a voltage level Vg (a scanning control voltage) of the scanning signal.

One terminal of the capacitor C1 is connected through a part of a wiring that branches at, for example, the node N1 (this is also comprised in the wiring L1) to the wiring L1. The other terminal of the capacitor C1 is connected to a sub-wiring that branches from the main wiring of the capacitance line L_{C} at, for example, a node N5. The capacitance line drive signal is applied to the capacitance line L_{C} from the capacitance-line driving unit 105 described above. A voltage level Vc (a capacitance line drive voltage) of the capacitance line drive signal can be, for example, a ground potential. In other words, the capacitance line L_{C} can be a ground line. In this case, the capacitance-line driving unit 105 can be omitted.

When the voltage level Vg (the scanning control voltage) of the scanning signal inputted to the scanning line L_{G} becomes a high level, the switching transistor Q1 is switched on and charges according to a voltage level Vd (a data drive voltage) of the data signal are injected in the gate G of the driving transistor Q2 through the switching transistor Q1. As a result, the driving transistor Q2 is switched on and a path between the node N3 and the organic-light emitting diode D1 is conducted.

The capacitor C1 maintains the electric potential of the gate G of the driving transistor Q2 from when the voltage level Vg of the scanning line L_{G} becomes a low level and the switching transistor Q1 is totally switched off to when the voltage level Vg becomes a high level, the switching transistor Q1 is switched on, and the next data signal is inputted. That is, the capacitor C1 holds data inputted to the data line L_{D} for a predetermined period.

The driving transistor Q2 is, for example, an n-type TFT and its drain D is connected to a sub-wiring branched from the main wiring of the drive line L_{P} at, for example, a node N6 and its source S is connected via a node N2 to an anode of the organic-light emitting diode D1. The common voltage Vcom (for example, the ground potential GND) is applied to the cathode of the organic-light emitting diode D1. When the driving transistor Q2 is thus switched on and a supply voltage VDD is applied to the anode, a current I flows in the organic-light emitting diode D1. The organic-light emitting diode D1 thus emits light with a brightness depending on an amount of the current I. When the driving transistor Q2 is switched off, the current does not flow in the organic-light emitting diode D1 and thus light is not emitted.

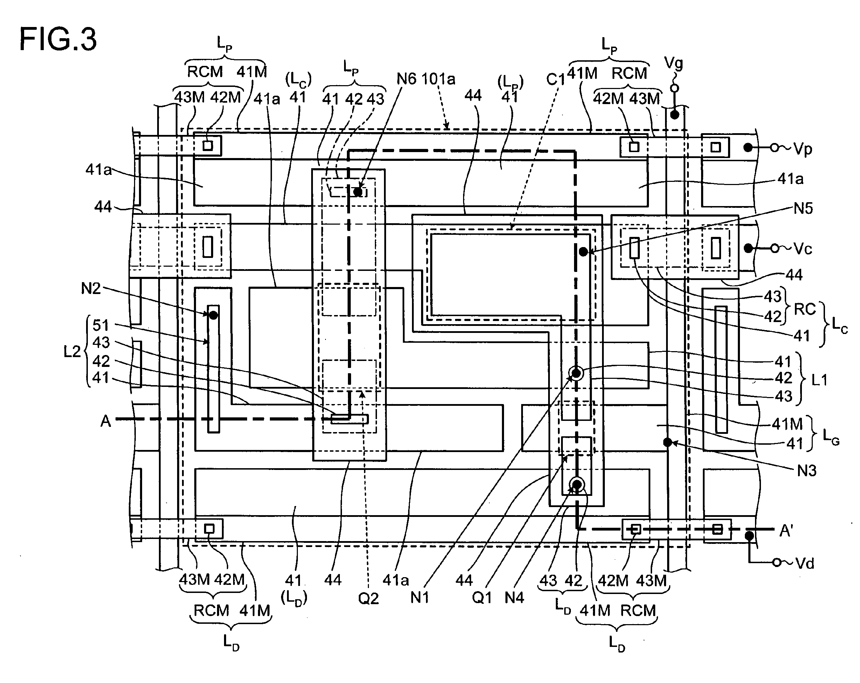

A layout structure and a layer structure of each of the pixels 101a are described next in detail with reference to Figs. 3 and 4. Fig. 3 is a schematic plan view for explaining the layout structure of the active matrix substrate 101A (see Fig. 4, for example) in the pixel 101a. Fig. 4 is a schematic cross-sectional view for explaining the layer structure of the pixel 101a. Structures such as a transparent substrate 10 and interlayer insulating films 40 and 50 (see Fig. 4, for example) will be omitted in Fig. 3 to simplify the descriptions. Fig. 4 depicts a schematic layer structure of the pixel 101a and a cut end facet along a line A-A' shown in Fig. 3 is continuously shown. For clear explanations, in the following descriptions, like reference letters or numerals are denoted to a film of a same type in a same layer.

As shown Fig. 3 or Fig. 4, the pixel 101a comprises the active matrix substrate 101A (see Fig. 4, for example) serving as an array substrate and the organic-light emitting diode D1 (see Fig. 4, for example) on the active matrix substrate 101A. The active matrix substrate 101A comprises, for example, the scanning line L_{G}, the data line L_{D}, the capacitance line L_{C}, the drive line L_{P}, the wiring L1 and L2, the switching transistor Q1, the driving transistor Q2, and the capacitor C1. The organic-light emitting diode D1 comprises an organic film 62 sandwiched between an anode electrode 61 and a cathode electrode 63 and is connected to a source electrode 24s of the driving transistor Q2 through, for example, the wiring L2. A color filter may be provided on a light outputting side of the organic-light emitting diode D1.

The scanning line L_{G} is constituted by a first wiring layer that comprises a first metal wiring 41M (the main wiring) and a transparent wiring 41 (the sub-wiring) on the transparent substrate 10 (see Fig. 3, for example). The data line L_{D} and the drive line L_{P} are constituted by the first wiring layer that comprises the first metal wiring 41M and the transparent wiring 41 on the transparent substrate 10, a second wiring layer 43 on the interlayer insulating film 40, a contact hole wiring 42 in a contact formed in the interlayer insulating film 40, and a three-dimensional wiring RCM that is composed of a contact hole metal wiring 42M and a second metal wiring 43M for connecting the first metal wiring 41M between adjacent pixels 101a. The wirings L1 and L2 is composed of the first wiring layer on the transparent substrate 10, the second wiring layer 43 on the interlayer insulating film 40, and the contact hole wiring 42 in a contact hole formed in the interlayer insulating film 40. The wiring L2 also comprises a contact plug 51 for electrically connecting the second wiring layer 43 connected to the source electrode 24s of the driving transistor Q2 to the anode electrode 61 of the organic-light emitting diode D1. The nodes N1, N2, N3, N4, N5, and N6 shown in Fig. 2 can be defined at respective positions shown in Fig. 3.

In the first wiring layer, the first metal wiring 41M that extends in the substantially row direction or the substantially column direction corresponds to the main wiring of the scanning line L_{G}, the data line L_{D}, or the drive line L_{P}. The transparent wiring 41 is a part of a wiring that branches from the main wiring to connect the main wiring to elements (such as Q1, Q2, and C1) of each of the pixels 101a and corresponds to the sub-wiring of the wiring (such as L_{G}, L_{D}, and L_{P}). A part of the capacitance line L_{C} that extends in the substantially column direction corresponds to the main wiring and a part thereof that branches from the main wiring corresponds to the sub-wiring. However, the present invention is not limited thereto, and the main wiring of the capacitance line L_{C} that extends in the substantially column direction may be constituted by the first metal wiring 41M.

The contact hole wiring 42 and the second wiring layer 43 are for electrically guiding the data line L_{D}, the capacitance line L_{C}, or the drive line Lp on the interlayer insulating film 40 and are comprised in the sub-wiring of the wiring (such as L_{G}, L_{D}, and L_{P}). The contact hole wiring 42 and the second wiring layer 43 that constitute the three-dimensional wiring RC for electrically connecting between the main wirings of the capacitance line L_{C} are comprised in the main wiring part.

Further, the contact hole metal wiring 42M and the second metal wiring 43M is the three-dimensional wiring RCM that extends across the scanning line L_{G} extending in a substantially vertical direction to the wiring (such as L_{D} and L_{P}) so that a path between the main wirings of the wiring (such as L_{D} and L_{P}) is electrically continuous and comprised in the main wiring part of the wiring (such as L_{D} and L_{P}).

As described above, the transparent wiring 41 or the first metal wiring 41M under the interlayer insulating film 40 is electrically connected to the second wiring layer 43 or the second metal wiring 43M on the interlayer insulating film 40 by using the contact hole wiring 42 or the contact hole metal wiring 42M formed in the interlayer insulating film 40 (see Fig. 4, for example). The signal lines (such as L_{G}, L_{D}, and L_{P}) can thus three-dimensionally intersect with each other. Most of the wiring (such as L_{G}, L_{D}, and L_{P}) can be formed in a single layer (a layer on the transparent substrate 10 in the present embodiment). Accordingly, the layer structure can be simplified and the wiring layout can be clarified in the active matrix substrate 101A. Further, flatness of a top surface of a layer placed at a higher position can be improved.

A redundant wiring 41a (see Fig. 3, for example) provided by making a part of the transparent wiring 41 of the first wiring layer redundant is formed in a region on the transparent substrate 10 where the wiring (such as L_{G}, L_{D}, L_{C}, L_{P}, L1, and L2) and the various elements (such as Q1, Q2, and C1) are not formed. The flatness of the top surface of the layer formed on the transparent substrate 10 is improved.

The switching transistor Q1 is, for example, a so-called bottom-gate structure thin film transistor (TFT) that is composed of a gate electrode 11 on the transparent substrate 10, a gate insulating film 12 that covers the gate electrode 11, a source electrode 14s and a drain electrode 14d on the gate insulating film 12, and a transparent semiconductor layer 13 between the source electrode 14s and the drain electrode 14d on the gate insulating film 12 (see Fig. 4, for example).

A part of the transparent wiring 41 of the first wiring layer that constitutes the scanning line L_{G}, for example, can be used for the gate electrode 11. A part of the interlayer insulating film 40 can be used for the gate insulating film 12. A part of a transparent semiconductor layer 44 can be used for the transparent semiconductor layer 13, for example. A part of the second wiring layer 43 that constitutes a part of the data line L_{D} can be used for the source electrode 14s, for example. A part of the second wiring layer 43 that constitutes a part of the wiring L1 can be used for the drain electrode 14d, for example. However, the present invention is not limited thereto, and a so-called top-gate structure thin film transistor (TFT) that a part of the second wiring layer 43 is used for the gate electrode 11 and a part of the transparent wiring 41 of the first wiring layer is used for the source electrode 14s and the drain electrode 14d may be utilized.

Similarly, the driving transistor Q2 is, for example, a so-called bottom-gate structure thin film transistor (TFT) that is composed of a gate electrode 21 on the transparent electrode 10, a gate insulating film 22 that covers the gate electrode 21, the source electrode 24s and a drain electrode 24d on the gate insulating film 22, and a transparent semiconductor layer 23 between the drain electrode 24d and the source electrode 24s on the gate insulating film 22 (see Fig. 4, for example).

A part of the transparent wiring 41 of the first wiring layer that constitutes a part of the wiring L1 can be used for the gate electrode 21, for example. A part of the interlayer insulating film 40 can be used for the gate insulating film 22, for example. A part of the transparent semiconductor layer 44 can be used for the transparent semiconductor layer 23, for example. A part of the second wiring layer 43 that constitutes a part of the drive line L_{P} can be used for the drain electrode 24d, for example. A part of the second wiring layer 43 that constitutes a part of the wiring L2 can be used for the source electrode 24s, for example. However, the present invention is not limited thereto, and a so-called top-gate structure TFT that a part of the second wiring layer 43 is used for the gate electrode 21 and a part of the transparent wiring 41 of the first wiring layer is used for the drain electrode 24d and the source electrode 24s may be utilized.

The active matrix substrate 101A according to the present embodiment is a so-called array substrate that comprises a TFT serving as a transistor element.

The capacitor C1 is composed of, for example, a lower electrode 31 on the transparent substrate 10, an upper electrode 33 above the lower electrode 31, and a capacitive insulating film 32 between the lower electrode 31 and the upper electrode 33 (see Fig. 4, for example). A part of the transparent wiring 41 of the first wiring layer that constitutes a part of the capacitance line L_{C} can be used for the lower electrode 31. A part of the interlayer insulating film 40 can be used for the capacitive insulating film 32. A part of the second wiring layer 43 that constitutes the drive line L_{P} can be used for the upper electrode 33.

Further, the organic-light emitting diode D1 on the active matrix substrate 101A is composed of, for example, the anode electrode 61, the organic film 62 on the anode electrode 61, and the cathode electrode 63 on the organic film 62 (see Fig. 4, for example). A color conversion film such as a color filter or a wavelength shifter may be placed on a layer on the light outputting side of the organic-light emitting diode D1. In Fig. 4, a light emission direction (a light outputting direction) is indicated by a solid white arrow.

A partition wall 70 for partitioning the color filter 64, the anode electrode 61, and the organic film 62 for each pixel is formed between adjacent pixels 101a (see Fig. 4, for example). A passivation film 80 for protecting the organic-light emitting diode D1 and the elements and the wiring in the underlying layers is formed above the interlayer insulating film 50 (see Fig. 4, for example).

A glass substrate may be used for the transparent substrate 10. However, the present invention is not limited thereto, and various transparent insulating substrates such as a glass substrate, a quartz substrate, and a plastic substrate may be used. When a flexible substrate is used for the transparent substrate 10, a flexible organic EL display device 100 can be realized. The word "transparent" in the present invention means transparent or semi-transparent with respect to light of wavelengths included in at least a visible light band.

The transparent wiring 41, the contact hole wiring 42 and the second wiring layer 43, and the contact plug 51 are made of a conductive material whose main ingredient is zinc tin oxide (ZTO). However, the present invention is not limited thereto and an indium containing oxide such as indium tin oxide (ITO), other conductive inorganic oxide conductive material, and an organic conductive material that can obtain a transparent conductive film may be used. The ZTO material can be used as the conductive material when an amount (a molar amount) of Sn is larger than that of Zn (for example, a Zn:Sn molar ratio of 1:2). ITO as the conductive material generally has an In:Sn molar ratio of about 0.9:0.1. IZO as the conductive material generally has an In:Zn molar ratio of about 0.9:0.1.

A ZTO conductive film is particularly advantageous because it can be formed as an amorphous film and thus the flexible transparent wiring 41, the flexible second wiring layer 43, the flexible contact hole wiring 42, and the flexible contact plug 51 can be realized. Because the amorphous ZTO conductive film can be formed at a low temperature, it can be easily formed even when a substrate with a low resistance to a high temperature, for example, a plastic substrate is used as the transparent substrate 10. Accordingly, forming the transparent wiring 41, the second wiring layer 43, the contact hole wiring 42, and the contact plug 51 by using the ZTO conductive film is appropriate when the flexible organic EL display device 100 is produced.

The first metal wiring 41M has a higher conductivity than that of the transparent wiring 41 described above. This first metal wiring 41M may be made of aluminum (Al) that has a higher conductivity than that of the ZTO conductive material. However, the present invention is not limited thereto, and the first metal wiring 41M can be formed by using a conductive film of one or more layers that comprises one or more metal materials with a higher conductivity than that of the transparent wiring 41 such as aluminum (Al), silver (Ag), copper (Cu), and molybdenum (Mo) or one or more alloy materials thereof, or a conductive film of one or more layers that comprises other conductive material with a higher conductivity than that of the transparent wiring 41.

In this manner, because at least a part of the main wiring is formed by using a material with a higher conductivity than that of another wiring (the sub-wiring), the cross-sectional area (particularly the width) of the main wiring can be reduced. A ratio of the main wiring to the light outputting surface of the active matrix substrate 101A can be reduced and thus the aperture ratio of the active matrix substrate 101A can be improved. Because the main wiring is formed of the first metal wiring 41M with a high conductivity, the resistance of the main wiring can be reduced and the drive voltage of the active matrix substrate 101A can be also reduced. Consequently, the consumption power of the organic EL display device 100 can be reduced.

The contact hole metal wiring 42M and the second metal wiring 43M that connect between the first metal wiring 41M can be formed by using aluminum (Al) with a higher conductivity than that of the ZTO conductive material, like the first metal wiring 41M. However, the present invention is not limited thereto, and a conductive film of one or more layers that comprises one or more metal materials such as aluminum (Al), silver (Ag), copper (Cu), and molybdenum (Mo) and alloy materials thereof or a conductive film of one or more layers that comprises other conductive material can be used. The resistance of the main wiring can be further reduced. Instead of the contact hole metal wiring 42M and the second metal wiring 43M, the contact hole wiring 42 and the second wiring layer 43 may be formed. In this case, the contact hole wiring 42 and the second wiring layer 43 may be covered by the transparent semiconductor layer 44.

For example, a transparent insulating single layer film made of a silicon insulating material such as SOG (Spin On Glass), silicon oxide (SiO₂), or silicon nitride (SiN_{X}), an aluminum oxide such as alumina (Al₂O₃), a hafnium oxide such as hafnia (HfO₂), a yttrium oxide such as yttria (Y₂O₃), a lanthanum oxide such as La₂O₃, or an insulating material that can be formed by a coating process such as a transparent photosensitive resin and a transparent insulating multilayer film that comprises one or more of these materials can be used for the interlayer insulating films 40 and 50. According to the present embodiment, the interlayer insulating film 40 is formed of, for example, an insulating film of a multilayer structure that comprises an alumina (Al₂O₃) film and a hafnia (HfO₂) film and the interlayer insulating film 50 is formed of, for example, a single layer structure insulating film made of a photosensitive resin. According to the present embodiment, the interlayer insulating films 40 and 50 function as a flattening film for securing flatness of the layers, in addition to functioning as an insulating film for insulating between the layers.

The transparent semiconductor layer 44 is formed on the interlayer insulating film 40 so as to cover the second wiring layer 43 and the contact hole wiring 42. The transparent semiconductor layer 44 functions as a protection film or the like for reducing process damages subjected to the underlying second wiring layer 43 and the contact hole wiring 42 during, for example, an etching step at a manufacturing step to be described later. According to the present embodiment, a transparent semiconductor layer made of a semiconductor material that can reduce a carrier density as compared to the wiring made of the conductive material (the ZTO conductive material or the indium containing oxide conductive material) and that is made of ZTO or indium containing oxide is used as the transparent semiconductor layer 44. The ZTO material can be used as the semiconductor material when the (molar) amount of Zn is larger than that of Sn (for example, a Zn:Sn molar ratio of 2:1). When the ZTO semiconductor layer is formed, the carrier density of the semiconductor layer is adjusted to be low by increasing an oxygen density of an atmosphere. Because the ZTO transparent semiconductor layer can be also formed as an amorphous film like the ZTO conductive film made of the ZTO conductive material described above, the flexible transparent semiconductor layer 44 can be realized, which is appropriate for forming the flexible organic EL display device 100. However, the present invention is not limited such a ZTO semiconductor material, and various transparent semiconductor materials comprising a transparent inorganic oxide semiconductor material such as an indium containing oxide semiconductor material (for example, IZO with an In:Zn molar ratio of 4:6) and a transparent organic semiconductor material such as a precursor of pentacene or tetrabenzoporphyrine.

According to the present embodiment, a material of the same type is used for the main ingredient of a conductive material that forms the transparent semiconductor layer 44 and the main ingredient of a conductive material that forms an electrode that contacts the transparent electrode in the respective elements. Accordingly, in the present embodiment, the second wiring layer 43 that comprises the source electrode 14s and the drain electrode 14d and the source electrode 24s and the drain electrode 24d is formed of a ZTO conductive film whose main ingredient is ZTO, and the transparent semiconductor layer 44 is formed of a ZTO semiconductor film whose main ingredient is ZTO and whose carrier density is higher than that of the second wiring layer 43. By forming these layers with the material of the same type, the source electrode 14s or the drain electrode 14d can ohmic contact the transparent semiconductor layer 13 in the switching transistor Q1. Similarly, the drain electrode 24d or the source electrode 24s can ohmic contact the transparent semiconductor layer 23 in the driving transistor Q2. Resistance ingredients of the TFT elements (such as Q1 and Q2) are thus reduced and the drive power of the TFT elements can be reduced. Consequently, consumption power of the organic EL display device 100 can be reduced.

The partition wall 70 can be formed of, for example, an insulating film of a single layer structure made of a photosensitive resin. However, the present invention is not limited thereto, and a transparent insulating single layer film made of a silicon insulating material such as SOG, SiO₂, or SiN_{X}, an aluminum oxide such as Al₂O₃, a hafnium oxide such as HfO₂, a yttrium oxide such as Y₂O₃, a lanthanum oxide such as La₂O₃, or an insulating material that can be formed by a coating process such as a transparent photosensitive resin and a transparent insulating multilayer film that includes one or more of these materials may be used.

Because the switching transistor Q1, the driving transistor Q2, and the capacitor C1 can be composed of using a part of the first wiring layer, the second wiring layer 43, and the interlayer insulating film 40 described above, their materials may be same as those described above. Appropriate modifications such as forming a transparent conductive film for reducing the resistance of the electrodes on the electrodes can be made.

In the organic-light emitting diode D1, the organic film 62 is, for example, a stacked film of a multilayer structure that comprises a hole injection layer, a hole transporting layer, an organic light emitting layer, an electron transporting layer, an electron injection layer, and a hole barrier layer. In the organic film 62, various light emitting materials such as macromolecular materials such as polyfluorene, derivatives and copolymers thereof, polyarylene, derivatives and copolymers thereof, polyarylene vinylene, derivatives and copolymers thereof, polyarylamine, derivatives and copolymers thereof, various fluorescent or phosphorescent low molecular light emitting materials or macromolecular materials may be used for a host material of the organic light emitting layer according to combinations with the hole transporting layer and a target wavelength.

A transparent single layer film made of an oxide conductive material such as ZTO or ITO or a metal material such as silver (Ag) or aluminum (Al) and a transparent stacked film of a multilayer structure that comprises these materials can be used for the anode electrode 61 placed on the light outputting side. When the metal material is used, a layer that comprises this material is made thin so that light is transmitted. According to the present embodiment, a case that a stacked film of ZTO/Ag/ZTO is used and an Ag film in this film is made thin so as to transmit light is described. The cathode electrode 63 may use a conductive material such as metal that has a high conductivity and a high reflectance such as silver (Ag), aluminum (Al), or magnesium (Mg) or alloy thereof. A case that an alloy film of Mg and Ag is used is described in the present embodiment.

The passivation film 80 can be formed by using a multilayer film of an SiO₂ film and an SiN_{X} film formed by a CVD method. A case that the multilayer film of the SiO₂ film and the SiN_{X} film is used is provided in the present embodiment.

As is clear from the above descriptions, according to the organic EL display device 100 of the present embodiment, at least a part of the main wiring has a larger conductivity than that of other wirings. A width in a vertical direction to the light emission direction of the main wiring can thus be reduced. Accordingly, the ratio of the main wiring to the light outputting surface of the active matrix substrate 101A can be reduced and thus the aperture ratio of the active matrix substrate 101A can be improved. Because the main wiring is formed of the first metal wiring 41M with a high conductivity, the resistance of the main wiring can be reduced and thus the drive voltage of the active matrix substrate 101A can be reduced. Consequently, the consumption power of the organic EL display device 100 can be reduced.

### (Manufacturing Method)

A method for manufacturing the organic EL display device 100 according to the present embodiment is described next in detail with reference to the drawings. Figs. 5-1 to 5-12 are process cross-sectional views of a method for manufacturing the display panel 101 of the organic EL display device 100 according to the present embodiment. Figs. 5-1 to 5-12 depict a continuous end facet cut along the line A-A' shown in Fig. 3.

According to this manufacturing method, the transparent substrate 10 is prepared first and a ZTO/Al stacked film is deposited on one of two main surfaces vertical to a thickness direction of the substrate (hereinafter, this surface is a top surface) by, for example, sputtering method, CVD (Chemical Vapor Deposition) method, or vacuum deposition method, so that a ZTO/Al stacked film of a transparent amorphous ZTO conductive film and an Al metal film is formed. Only the Al film of the ZTO/Al stacked film is patterned by, for example, photolithography method (in the present specification, "photolithography method" can comprise a patterning step such as an etching step.), so that the first metal wiring 41M serving as the main wiring is formed on the underlying ZTO conductive film (a main wiring forming step 1). However, the present invention is not limited to this case and the first metal wiring 41M may be formed by a coating process technique such as a printing technique utilizing metal nanoparticle dispersion or an ink jet printing technique. The ZTO conductive film is then patterned by photolithography method, so that the transparent wiring 41 that comprises the gate electrodes 11 and 21, the lower electrode 31, and the redundant wiring 41a (see Fig. 3) is formed on the transparent substrate 10 (a first sub-wiring forming step). However, the present invention is not limited thereto, and the transparent wiring 41 may be formed by a coating process technique using a sol gel method. By this step, the first wiring layer that is composed of the transparent wiring 41 and the first metal wiring 41M is formed on the transparent substrate 10 as shown in Fig. 5-1.

Alumina (Al₂O₃) and hafnia (HfO₂) are successively deposited on the top surface of the transparent substrate 10 with the electrodes and the wiring (such as 11, 21, 31, 41, 41a, and 41M) being formed thereon by sputtering method, CVD method, or vacuum deposition method, so that the interlayer insulating film 40 formed of a transparent insulating stacked film is formed (a first interlayer insulating film forming step). The interlayer insulating film 40 is then patterned by photolithography method, so that the contact holes ap1 and ap2 that expose parts of the transparent wiring 41 and the first metal wiring 41M other than their electrode portion are formed in the interlayer insulating film 40 as shown in Fig. 5-2. However, the present invention is not limited to such a case, and the interlayer insulating film 40 with the contact holes ap1 and ap2 can be formed by using the coating process technique described above. In the interlayer insulating film 40 formed at this step, at least a part of the interlayer insulating film 40 on the gate electrode 11 functions as the gate insulating film 12 of the switching transistor Q1, at least a part of the interlayer insulating film 40 on the gate electrode 21 functions as the gate insulating film 22 of the driving transistor Q2, and at least a part of the interlayer insulating film 40 on the lower electrode 31 functions as the capacitive insulating film 32 of the capacitor C1. Further, the contact hole ap2 is a contact hole for forming a part of the contact plug 51 electrically connected to the transparent wiring 41 of the first wiring layer at a subsequent step.

ZTO is then deposited on the interlayer insulating film 40 with the contact holes ap1 and ap2 being formed therein by, for example, sputtering method, CVD method, or vacuum deposition method, so that a transparent amorphous ZTO conductive film is formed. At this time, the ZTO conductive film may be formed in the contact hole ap2. The ZTO conductive film is then patterned by, for example, photolithography technique or etching technique. The ZTO conductive film in and around the contact hole ap1 that exposes the first metal wiring 41M serving as the main wiring is also removed. As shown in Fig. 5-3, the source electrode 14s and the drain electrode 14d, the drain electrode 24d and the source electrode 24s, the upper electrode 33, and the second wiring layer 43 are formed on the interlayer insulating film 40, and the contact hole wiring 42 electrically connected to the transparent wiring 41 is formed in the contact hole ap1 of the interlayer insulating film 40 (a second sub-wiring forming step). However, the present invention is not limited thereto. For example, the source electrode 14s and the drain electrode 14d, the drain electrode 24d, the source electrode 24s, the upper electrode 33, the contact hole wiring 42, and the second wiring layer 43 may be formed by the coating process technique described above. The ZTO conductive film within the contact hole ap2 does not need to be removed completely at this step.

Al is then deposited on the interlayer insulating film 40 with the electrodes and the wiring (such as 14s, 14d, 24d, 24s, 33, 42, 42a, 43, and 43a) being formed thereon by, for example, sputtering method, CVD method, or vacuum deposition method, so that an Al film is formed. The Al film is patterned by photolithography method, so that the second metal wiring 43M for connecting between the first metal wiring 41M serving as the main wiring is formed on the interlayer insulating film 40, and the contact hole metal wiring 42M electrically connected to the first metal wiring 41M serving as the main wiring is formed in the contact hole ap1 that exposes the first metal wiring 41M as shown in Fig. 5-4 (a main wiring forming step 2). However, the present invention is not limited to this case and the contact hole metal wiring 42M and the second metal wiring 43M may be formed by using the coating process technique described above.

ZTO is then deposited on the interlayer insulating film 40 with the electrodes and the wiring (such as 14s, 14d, 24d, 24s, 33, 42, 43, 42M, and 43M) being formed thereon by, for example, sputtering method, CVD method, or vacuum deposition method, so that a ZTO semiconductor film whose carrier density is lower than that of the ZTO conductive film is formed (a semiconductor layer forming step). At this time, the ZTO semiconductor film may be formed in the contact hole ap2. As described above, by controlling a composition ratio of Zn and Sn, the ZTO semiconductor film can be a transparent semiconductor film whose carrier density is lower than that of the ZTO conductive film that constitutes the transparent wiring 41 of the first wiring layer and the second wiring layer 43. The ZTO semiconductor film is then patterned by photolithography technique / etching technique, so that the transparent semiconductor layer 44 that covers the electrodes and the wiring (such as 14s, 14d, 24d, 24s, 33, 42, and 43) is formed on the interlayer insulating film 40 as shown in Fig. 5-5. At this time, over etching is preferably performed so that the ZTO semiconductor film in the contact hole ap2 is completely removed. In the formed transparent semiconductor layer 44, at least a part of the transparent semiconductor layer 44 between the source electrode 14s and the drain electrode 14d functions as the transparent semiconductor layer 13 that serves as a channel forming layer of the switching transistor Q1. At least a part of the transparent semiconductor layer 44 between the drain electrode 24d and the source electrode 24s functions as the transparent semiconductor layer 23 that serves as a channel forming layer of the driving transistor Q2.

Because the transparent semiconductor layer 44, the second wiring layer 43, and the contact hole wiring 42 are made of a material of the same type in the present embodiment, a selection ratio of the transparent semiconductor layer 44 to the second wiring layer 43 during etching is difficult to be obtained. In the present embodiment, the transparent semiconductor layer 44 after patterning covers the second wiring layer 43 and the contact hole wiring 42. Accordingly, the second wiring layer 43 and the contact hole wiring 42 are not exposed to an etching atmosphere during etching. The transparent semiconductor layer 44 can thus be patterned without considering a selection ratio to the second wiring layer 43. However, the present invention is not limited thereto. For example, the transparent semiconductor layer 44 can be formed by using the coating process technique described above. In this case, the formed transparent semiconductor layer does not need to be patterned by etching, and thus the transparent semiconductor layer 44 does not need to cover the second wiring layer 43 and the contact hole wiring 42. Furthermore, according to the present embodiment, a selection ratio of the second metal wiring 43M and the contact hole metal wiring 42M to the transparent semiconductor layer 44 during etching can be obtained. Accordingly, the second metal wiring 43M and the contact hole metal wiring 42M does not need to be covered by the transparent semiconductor layer 44.

As described above, when the transparent semiconductor layer (such as 13, 23, and 44) is formed, a photosensitive resist liquid is then spin coated on the interlayer insulating film 40 with the transparent semiconductor layer (such as 13, 23, and 44) being formed thereon, and a resultant film is exposed to light and developed. As shown in Fig. 5-6, the interlayer insulating film 50 that comprises a contact hole ap3 that is continuous with the contact hole ap2 of the interlayer insulating film 40 and is made of a transparent photosensitive resin is formed (a second interlayer insulating film forming step). However, the present invention is not limited thereto. For example, the interlayer insulating film 50 with the contact hole ap3 may be formed by, for example, the coating process technique described above.

ZTO is then deposited on the interlayer insulating film 50 with the contact hole ap3 being formed therein by, for example, sputtering method, CVD method, or vacuum deposition method. As shown in Fig. 5-7, the transparent amorphous contact plug 51 electrically connected to the transparent wiring 41 of the first wiring layer is formed at least in the contact hole ap3 of the interlayer insulating film 50 and the contact hole ap2 of the interlayer insulating film 40. An unnecessary ZTO conductive film formed on the interlayer insulating film 50 is removed by, for example, etching back. However, the present invention is not limited thereto. The contact plug 51 may be formed in the interlayer insulating films 40 and 50 by, for example, the coating process technique described above.

By performing the steps described above, the active matrix substrate 101A as an array substrate is manufactured in the present embodiment.

ZTO, Ag, and ZTO are successively deposited on the active matrix substrate 101A by, for example, sputtering method, CVD method, or vacuum deposition method, so that a transparent ZTO/Ag/ZTO stacked film with an electrical contact to the contact plug 51 is formed. The ZTO/Ag/ZTO stacked film is then patterned by photolithography method, so that the anode electrode 61 electrically connected to the contact plug 51 is formed on the interlayer insulating film 50 as shown in Fig. 5-8. However, the present invention is not limited thereto, and the anode electrode 61 may be formed by, for example, the coating process technique described above.

A photosensitive resist liquid is then spin coated on the active matrix substrate 101A with the anode electrode 61 being formed thereon, and a resultant substrate is exposed to light and developed. As shown in Fig. 5-9, the partition wall 70 made of a transparent photosensitive resin is formed in a region on the active matrix substrate 101A where each of the pixels 101a is partitioned. However, the present invention is not limited thereto, and the partition wall 70 may be formed by, for example, the coating process technique described above.

The hole injection layer, the hole transporting layer, the organic light emitting layer, the electron transporting layer, the electron injection layer, and the hole barrier layer are then successively stacked at least on the anode electrode 61 by existing film forming techniques. As shown in Fig. 5-10, the organic film 62 is formed on the anode electrode 61 partitioned by the partition wall 70. The hole injection layer, the hole transport layer, the electron transport layer, the electron injection layer, and the hole block layer in the organic film 62 can be formed by a coating process such as a printing technique utilizing macromolecular polymer solutions or an ink jet printing technique. However, the present invention is not limited thereto, and the hole injection layer, the hole transport layer, the organic light emitting layer, the electron transport layer, the electron injection layer, and the hole block layer are formed successively by a shadow mask deposition method typified by vacuum deposition method and a laser thermal transfer method (an LITI method) and a laser re-deposition method (RIST and LIPS methods) typified by a transfer method, so that the organic film 62 according to the pixel 101a is formed. When a stacked film of an inorganic oxide conductive film and a conductive macromolecular polymer film such as ITO / PEDOT (3,4-ethylenedioxy thiophene):PSS (Polystyrene sulfonate) is used for the anode electrode 61, the organic film 62 can be a stacked film of the hole injection layer/the organic light emitting layer/the electron injection layer from the bottom.

An alloy material of Mg and Ag is then deposited on the entire active matrix substrate 101A with the organic film 62 and the partition wall 70 being formed thereon by vacuum deposition method, so that a conductive alloy film is formed. At this time, an excessive alloy film is prevented from being deposited on regions other than a desired region by a shadow mask method. As shown in Fig. 5-11, the cathode electrode 63 is formed at least on the entire region where the pixels (101a) are arranged. However, the present invention is not limited thereto, and the cathode electrode 63 may be formed by, for example, the coating process technique described above.

A multilayer film of SiO₂ and SiNx is formed on the entire top surface of the active matrix substrate 101A with the organic-light emitting diode D1 that is composed of the anode electrode 61 and the organic film 62 partitioned by the partition wall 70, and the cathode electrode 63 being formed thereon by CVD method. The passivation film 80 that protects the underlying elements (such as Q1, Q2, C1, and D1) and the wiring (such as L_{G}, L_{D}, L_{P}, L1, and L2) is thus formed. A substrate is attached to the top surface of the passivation film 80 that is opposite to the side the substrate 101A is placed for sealing. Alternatively, a film is formed by sputtering method or CVD method for sealing. By the steps described above, the display panel 101 that comprises the pixel 101a with the layer structure shown in Fig. 4 is manufactured. Examples of the substrate on the side of the passivation film 80 opposite to the side the substrate 101A is placed comprise glass, a transparent polymer film typified by PET, and a sealing film obtained by stacking alternately an organic film and an inorganic film by sputtering method or CVD method for improving a barrier property of the film.

Thereafter, the display panel 101 manufactured by the method described above is mounted to a housing in which the signal control unit 102, the scan driving unit 103, the data driving unit 104, the capacitance-line driving unit 105, the drive-signal generating unit 106, and other components are incorporated, so that the organic EL display device 100 according to the present embodiment is manufactured.

While the above manufacturing step comprises a step of washing a substrate and the like as appropriate, these steps will be omitted to simplify the descriptions.

As described above, according to the organic EL display device 100 of the present embodiment, at least a part of the main wiring has a larger conductivity than that of other wirings. The cross-sectional area (particularly the width) of the main wiring can be reduced, and thus the ratio of the main wiring to the light outputting surface of the active matrix substrate 101A can be reduced. Consequently, the aperture ratio of the active matrix substrate 101A can be improved. Because the main wiring is formed of the first metal wiring 41M with a high conductivity, the resistance of the main wiring can be reduced and the drive voltage of the active matrix substrate 101A can be also reduced. As a result, the consumption power of the organic EL display device 100 can be reduced.

Because the aperture ratio is improved, flexibility in the arrangement of a light emitting element (the organic-light emitting diode D1 according to the present embodiment) can be improved. Accordingly, the organic EL display device 100 with greater flexibility in design can be realized.

Further, according to the method for manufacturing the present embodiment, the contact hole wiring 42 and the second wiring layer 43 are covered by the transparent semiconductor layer 44 in a manufacturing process. Process damages subjected to the wirings (such as 42 and 43) at a subsequent etching step can thus be reduced.

Furthermore, layers that constitute the organic EL display device 100 may be formed by using a flexible material in the present embodiment.

While the present embodiment of the present invention describes the organic EL display device 100 that a light emitting layer (the organic film 62 according to the present embodiment) is made of an organic material, the present invention is not limited thereto, and an inorganic EL display device that the light emitting layer is made of an inorganic material can be provided.

### <Second embodiment>

An organic EL display device is then described as a display device according to a second embodiment of the present invention. In the present embodiment, the organic EL display device that can output light from a light emitting element (for example, an organic-light emitting diode D2 in Fig. 6) externally from a top surface (for example, a top surface 200a in Fig. 6) and a bottom surface (for example, a bottom surface 100a in Fig. 6) of the display panel 101 is described. In Fig. 6, a light emission direction (a light outputting direction) is indicated by a solid white arrow. That is, the organic EL display device according to the present embodiment is a so-called dual emission type organic EL display device that has functions of the top emission type and the bottom emission type. In the following descriptions, for clear explanations, constituent elements identical to those of the first embodiment of the present invention are denoted by like reference letters or numerals and explanations thereof will be omitted.

A functional configuration of the organic EL display device according to the present embodiment is the same as the schematic functional block configuration of the organic EL display device 100 shown in Fig. 1. The pixel 101a in Fig. 1 is substituted for a pixel 201a in the present embodiment. A schematic circuit configuration of the pixel 201a is the same as the schematic circuit configuration of the pixel 101a shown in Fig. 2. The organic-light emitting diode D1 in Fig. 2 is substituted for the organic-light emitting diode D2 in the present embodiment.

### (Pixel Configuration)

A layout structure and a layer structure of each of the pixels 201a are described next in detail. The layout structure of the active matrix substrate 101A in the pixel 201a according to the present embodiment is the same as that of the pixel 101a shown in Fig. 3. The schematic layer structure of the pixel 201a according to the present embodiment is shown in Fig. 6. Fig. 6 is a schematic cross-sectional view of the pixel 201a as a continuous end facet cut at the same position as the line A-A' in Fig. 3, like Fig. 4.

As is clear from a comparison of Fig. 6 to Fig. 4, according to the organic EL display device of the present embodiment, in the same configuration as that of the organic EL display device 100 according to the first embodiment of the present invention, the cathode electrode 63 (see Fig. 4, for example) is substituted for a cathode electrode 65 made of a transparent electrode material and an auxiliary electrode 66 for reducing a resistance of the cathode in the organic-light emitting diode D2 is provided on the cathode electrode 65.

The cathode electrode 65 can be made of an electrode material that can transmit visible light like, for example, the anode electrode 61. A transparent single layer film made of an oxide conductive material such as ZTO or ITO or a metal material such as silver (Ag) or aluminum (Al) and a transparent stacked film with a multilayer structure that comprises these materials can be used for the electrode material. When the metal material is used, a layer that comprises the metal material is a thin semi-transmissive film that transmits light. According to the present embodiment, a case that an alloy film of Mg and Ag is used and the cathode electrode is formed of a thin film that transmits light is described. In this manner, in addition to the bottom emission configuration of the first embodiment of the present invention, the cathode electrode 65 is constituted by a transparent electrode. A so-called dual emission type organic EL display device that can output light from the bottom surface 100a and the top surface 200a of the display panel 101 can thus be realized.

The auxiliary electrode 66 on the cathode electrode 65 is formed in a region on the active matrix substrate 101A where each of the pixels 201a is partitioned (for example, above the partition wall 70). A single layer film made of an inorganic oxide conductive material such as ZTO or ITO or a metal material such as silver (Ag) or aluminum (Al) and a stacked film with a multilayer structure that comprises these materials can be used for the auxiliary electrode material. When the auxiliary electrode 66 is placed on the region of each of the pixels 201a as in the present embodiment, the auxiliary electrode 66 does not need to be made of a transparent electrode material and can be made of a high conductive material such as Al or Ag. A case that the auxiliary electrode 66 is formed by using a conductive single layer film made of ZTO is described in the present embodiment. Because the auxiliary electrode 66 that reduces the resistance of the cathode in the organic-light emitting diode D2 is provided, a drive voltage of the organic-light emitting diode D2 can reduced. As a result, consumption power of the organic EL display device can be reduced.

### (Manufacturing Method)

A method for manufacturing the organic EL display device according to the present embodiment is obtained by substituting the step of forming the cathode electrode 63 shown in Fig. 5-11 for a step of forming the transparent cathode electrode 65 and adding a step of forming the auxiliary electrode 66 on the cathode electrode 65 in the manufacturing method that is the same as the method for manufacturing the organic EL display device 100 according to the first embodiment of the present invention. Because other manufacturing steps are same as the steps described in the first embodiment of the present invention with reference to Figs. 5-1 to Fig. 5-10 and Fig. 4, detailed descriptions thereof will be omitted.

At the step of forming the cathode electrode 65, a thin alloy film of Mg and Ag is deposited on the entire active matrix substrate 101A manufactured with reference to Figs. 5-1 to 5-10 by vacuum deposition method, so that the transparent cathode electrode 65 is formed. By using a shadow mask method, the cathode electrode 65 is formed on an entire desired region.

At the step of forming the auxiliary electrode 66, after the cathode electrode 65 is formed as at the step described above, an oxide conductive material such as ZTO or ITO or metal with a low resistance such as Ag, Al, or Cu is deposited at least on the cathode electrode 65 by sputtering method using shadow mask method, CVD method, or vacuum deposition method. As a result, the auxiliary electrode 66 is formed in the region on the top surface of the cathode electrode 65 above the partition wall 70.

After the passivation film 80 is formed as in the first embodiment of the present invention, the manufactured display panel 101 is mounted to the housing in which the signal control unit 102, the scan driving unit 103, the data driving unit 104, the capacitance-line driving unit 105, and the drive-signal generating unit 106 are incorporated, so that the organic EL display device of the present embodiment is manufactured.

While the manufacturing step described above comprises a step of washing a substrate and the like as appropriate, these steps will be omitted to simplify the descriptions.

As described above, according to the organic EL display device of the present embodiment, as in the first embodiment of the present invention, at least a part of the main wiring has a larger conductivity than that of other wirings. The cross-sectional area (particularly the width) of the main wiring can be reduced, and thus the ratio of the main wiring to the light outputting surface of the active matrix substrate 101A can be reduced. Consequently, the aperture ratio of the active matrix substrate 101A can be improved. Because the main wiring is formed of the first metal wiring 41M with a high conductivity, the resistance of the main wiring can be reduced and the drive voltage of the active matrix substrate 101A can be also reduced. As a result, the consumption power of the organic EL display device 100 can be reduced.

Because the aperture ratio is improved, the flexibility in the arrangement of a light emitting element (in the present embodiment, the organic-light emitting diode D2) can be improved. Accordingly, the organic EL display device with greater flexibility in design can be realized. Further, the organic EL display device of the present embodiment comprises the auxiliary electrode 66 for reducing the resistance of the cathode electrode 65. The drive voltage of the organic-light emitting diode D2 can thus be reduced. Consequently, the consumption power of the organic EL display device can be reduced. The organic EL display device of the present embodiment can be used for various purposes, for example, as a display used by attached to a transparent surface such as a window of a vehicle, a glass window, or a glass water tank.

Further, according to the method for manufacturing the present embodiment, the contact hole wiring 42 and the second wiring layer 43 are covered by the transparent semiconductor layer 44 in the manufacturing process as in the first embodiment of the present invention. Process damages subjected to the wiring (such as 42 and 43) at a subsequent etching step can be reduced.

Furthermore, layers that constitute the organic EL display device 100 can be formed by using flexible materials in the above embodiment.

According to the present embodiment, an inorganic EL display device that a light emitting layer is made of an inorganic material can be provided as in the first embodiment of the present invention. Further, according to the present embodiment, a reflection film (a reflector) is provided on a layer on the top or bottom side serving as one light emitting side, so that a top emission type or a bottom emission type organic EL display device with improved brightness can be realized.

### <Third embodiment>

A liquid-crystal display device 300 is then described as a display device according to a third embodiment of the present invention. Fig. 7 is a block diagram of a schematic configuration of the liquid-crystal display device 300. The present embodiment describes the liquid-crystal display device 300 that an element substrate (for example, see an active matrix substrate 301A in Fig. 10) is provided between a light source called backlight (for example, see a light source 350 in Fig. 10) and a liquid crystal element (for example, see a liquid crystal element E31 in Fig. 10). In the present embodiment, constituent elements identical to those of the first and second embodiments of the present invention are denoted by like reference letters or numerals and explanations thereof will be omitted.

### (Overall Configuration)

As shown in Fig. 7, the liquid-crystal display device 300 comprises a display panel 301 that comprises pixels (PX) 301a arranged in a two-dimensional matrix, the scan driving unit 103, the data driving unit 104, and the capacitance-line driving unit 105 that are connected to the display panel 301, and the signal control unit 102 that controls these units. The display panel 301 comprises the pixels 301a for three primary colors, that is, red (R), green (G), and blue (B), respectively.

Configurations of the signal control unit 102, the scan driving unit 103, the data driving unit 104, and the capacitance-line driving unit 105 are the same as those of the first embodiment of the present invention. A scanning control signal CONT1, a data control signal CONT2, a capacitance line control signal CONT3, and a video data signal DAT are generated as appropriate as signals that match a driving.method of the liquid crystal element and outputted. In the present embodiment, the drive line L_{P}, the drive-signal generating unit 106, and the light emission control signal CONT4 can be omitted.

The display panel 301 is connected to the scanning line L_{G}, the data line L_{D}, and the capacitance line L_{C}. According to the present embodiment, In the scanning line L_{G}, the data line L_{D}, and the capacitance line L_{C}, a part of a wiring that extend so as to intersect with other lines are called main wiring, and a part of a wiring that branches from the main wiring to be connected to a switching transistor Q31 or a storage capacitor C31 in each of the pixels 301a (see Fig. 8, for example) is called sub-wiring. A part of a wiring that connects between the elements is the sub-wiring. Because other configurations are the same as those of the first embodiment of the present invention, detailed descriptions thereof will be omitted.

### (Pixel Configuration)

A schematic configuration and an operation of each of the pixels 301a are described next with reference to Fig. 8. The following descriptions are applied to any of R, G, and B pixels 301a.

Fig. 8 is a schematic diagram of a schematic circuit configuration of the pixel 301a. As shown in Fig. 8, the pixel 301a comprises the switching transistor Q31, the storage capacitor C31, and the liquid crystal element E31.

The switching transistor Q31 is, for example, an n-type TFT and its source S is connected to the sub-wiring that branches from the main wiring of the data line L_{D} at, for example, a node N34 and its drain D is connected to a wiring L31 that comprises a node N31. A gate G of the switching transistor Q31 is connected to a sub-wiring that branches from the main wiring of the scanning line L_{G} at, for example, a node N33. The switching transistor Q31 conducts or disconnects between the data line L_{D} and the node N31 according to a voltage level Vg (a scanning control voltage) of a scanning signal.

One terminal of the storage capacitor C31 is connected to the wiring L31 through a part of a wiring that branches at, for example, the node N31 (this is also comprised in the wiring L31). The other terminal of the storage capacitor C31 is connected to a sub-wiring that branches from the main wiring of the capacitance line L_{C} at, for example, a node N35. A capacitance line drive signal that is outputted from the capacitance-line driving unit 105 is applied to the capacitance line L_{C} as in the first embodiment of the present invention. A voltage level Vc (a capacitance line drive voltage) of the capacitance line drive signal can be, for example, a ground potential. For example, the capacitance line is connected to a GND (Vcom) terminal that is the same common electrode as that of the liquid crystal element Cpx (E31). That is, the capacitance line L_{C} can be a ground line. In this case, the capacitance-line driving unit 105 can be omitted.

One electrode of the liquid crystal element E31 (for example, a pixel electrode 311 in Fig. 10) is also connected to the wiring L31. The other electrode of the liquid crystal element E31 is a common electrode (for example, a common electrode 313 in Fig. 10). Accordingly, the liquid crystal element E31 functions as a so-called liquid crystal capacitor Cpx on the circuit. The common voltage Vcom is applied to the common electrode 313 as shown in Fig. 7 or Fig. 8. In view of the connection relationship described above, the storage capacitor C31 and the liquid crystal element E31 function as a load capacitance connected in parallel to an output terminal of the switching transistor Q31. The common voltage Vcom can be, for example, a ground potential GND.

When the voltage level Vg (the scanning control voltage) of the scanning signal inputted to the scanning line L_{G} becomes a high level, the switching transistor Q31 is switched on and charges are injected in the pixel electrode 311 (see Fig. 10, for example) of the liquid crystal element E31 via the switching transistor Q31. Consequently, the potential of the pixel electrode 311 is a voltage level Vd of a data signal, a potential difference (Vd-Vcom) is generated between the pixel electrode 311 and the common electrode 313 (see Fig. 10, for example), and thus a molecular arrangement of the liquid crystal element E31 is changed.

The storage capacitor C31 functions to maintain the potential of the pixel electrode 311 from when the voltage level Vg of the scanning line L_{G} becomes a low level and the switching transistor Q31 is completely switched off to when the voltage level Vg becomes a high level again, the switching transistor Q31 is switched on, and the next data signal is inputted. That is, the storage capacitor C31 holds a data signal S_{D} inputted to the data line L_{D} for a predetermined period.

A so-called inversion driving method in which a polarity of the data signal inputted to the data line L_{D} and a potential of the capacitance line drive signal inputted to the capacitance line L_{C} are inverted for every predetermined period can be utilized in the present embodiment. While examples of the inversion driving method comprise a dot inversion driving method and a line inversion driving method, any of the inversion driving methods can be utilized.

A layout structure and a layer structure of each of the pixels 301a are described next in detail with reference to Figs. 9 and 10. Fig. 9 is a schematic plan view for explaining the layout structure of the active matrix substrate 301A in the pixel 301a (see Fig. 10, for example). Fig. 10 is a schematic cross-sectional view for explaining the layer structure of the pixel 301a. The transparent substrate 10, the interlayer insulating films 40 and 50, and an opposing substrate 302A (see Fig. 10, for example) will be omitted in Fig. 9 to simplify the descriptions. Fig. 10 depicts a schematic layer structure of the pixel 301a that corresponds to a continuous end facet cut along a line B-B' shown in Fig. 9.

As shown in Fig. 9 or Fig. 10, the pixel 301a comprises the active matrix substrate 301A as an array substrate (see Fig. 10, for example), the opposing substrate 302A that opposes the substrate 301A (see Fig. 10, for example), and the liquid crystal element E31 between the active matrix substrate 301A and the opposing substrate 302A (see Fig. 10, for example). The active matrix substrate 301A comprises, for example, the scanning line L_{G}, the data line L_{D}, the capacitance line L_{C}, the wiring L31, the switching transistor Q31, and the storage capacitor C31. The opposing substrate 302A comprises a light shielding film 321 serving as a black matrix for preventing undesired leakage of light and a color filter 64 that transmits a wavelength of an appropriate band for each of the pixels 301a. The liquid crystal element E31 comprises a pixel electrode 311 and the common electrode 313 that sandwich a liquid crystal layer 312 and alignment films 314 and 315 that further sandwich the layer 312, and is placed on the active matrix substrate 301A so as to be connected to the switching transistor Q31 and the storage capacitor C31 through the wiring L31. The opposing substrate 302A is placed so as to sandwich the liquid crystal element E31 with the active matrix substrate 301A. A laminate structure that is composed of the active matrix substrate 301A, the liquid crystal element E31, and the opposing substrate 302A is sandwiched between polarizing plates 330 and 340 that transmit only light that vibrates in a predetermined direction.

The scanning line L_{G}, the data line L_{D}, the capacitance line L_{C}, and the wiring L31 are respectively constituted by at least a part of the first metal wiring 41M, the contact hole metal wiring 42M, the second metal wiring layer 43M, and the contact plug 51 as in the first embodiment of the present invention. The switching transistor Q31 is composed of a gate electrode 15 that is a part of the first wiring layer 41 that constitutes the scanning line L_{G}, a gate insulating film 16 that is a part of the interlayer insulating film 40, a source electrode 18s that is a part of the second wiring layer 43 that constitutes a part of the data line L_{D}, a drain electrode 18d that is a part of the second wiring layer 43 that constitutes a part of the wiring L31, and a transparent semiconductor layer 17 that is a part of the transparent semiconductor layer 44. Further, the storage capacitor C31 is constituted by a lower electrode 35 that is a part of the first wiring layer 41 that constitutes the wiring L31, a capacitive insulating film 36 that is a part of the interlayer insulating film 40, and an upper electrode 37 that is a part of the second wiring layer 43 that constitutes the capacitance line L_{C}. The nodes N31 and N33 to N35 shown in Fig. 8 can be defined at respective positions shown in Fig. 9.

While the switching transistor Q31 according to the present embodiment is a so-called bottom-gate structure TFT like the switching transistor Q1 according to the first embodiment of the present invention, the present invention is not limited to this case and a top-gate structure TFT can be used. The active matrix substrate 301A according to the present embodiment is a so-called array substrate like the active matrix substrate 101A according to the first embodiment of the present invention.

The redundant wiring 41a provided by making a part of the transparent wiring 41 of the first wiring layer redundant (see Fig. 9, for example) is formed in a region on the transparent substrate 10 where various wirings (L_{G}, L_{D}, L_{C}, and L31) and various elements (Q31 and C31) are not formed as in the first embodiment of present invention, and thus the flatness of the top surface of the layer formed on the transparent substrate 10 is improved. According to the present embodiment, the transparent semiconductor layer 44 functions as a protection film for reducing process damages subjected to the underlying second wiring layer 43 and the contact hole wiring 42, as well as a channel layer for an element (for example, the switching transistor Q31).

Further, the liquid crystal element E31 on the active matrix substrate 301A with the above configuration is composed of, for example, the pixel electrode 311, the liquid crystal layer 312 above the pixel electrode 311, the common electrode 313 above the liquid crystal layer 312, and the alignment films 314 and 315 that sandwich the liquid crystal layer 312 in a vertical direction (see Fig. 10, for example). A substantially triangular shaped dielectric projection 316 can be provided on the top of the liquid crystal layer 312 in the liquid crystal element E31 (see Fig. 10, for example). A black matrix for preventing undesired leakage of light from the light source 350 and a color conversion film such as a color filter or a wavelength shifter can be placed on a light outputting side of the liquid crystal element E31. The present embodiment describes a case that the light shielding film 321 serving as a black matrix and the color filter 64 are placed between the common electrode 313 and the opposing substrate 302A.

Furthermore, the polarizing plates 330 and 340 that sandwich the active matrix substrate 301A and the opposing substrate 302A are provided at outer sides of the substrates 301A and 302A. The light source 350 is placed below the active matrix substrate 301A. Accordingly, light from the light source 350 passes through the polarizing plate 330, the active matrix substrate 301A, the liquid crystal element E31, the color filter 64, the opposing substrate 302A, and the polarizing plate 340 to be outputted externally from a top surface 300a that is the light outputting surface of the display panel 301. In Fig. 10, a light emission direction (a light outputting direction) is indicated by a solid white arrow.

The first wiring layer 41, the interlayer insulating film 40, the transparent semiconductor layer 44, and the second wiring layer 43 can be made of the same materials as those of the first embodiment of the present invention. The switching transistor Q31 and the storage capacitor C31 can be also made of the same materials. The transparent substrate 10, the contact hole wiring 42, the contact plug 51, and the interlayer insulating film 50 can be made of the same materials as those of the first embodiment of the present invention.

Various filter materials comprising a photosensitive resin prepared by mixing predetermined pigments so that wavelengths of bands appropriate for R, G, and B pixels 301a are transmitted can be used for the color filter 64. The present embodiment describes a case that a transparent photosensitive resin prepared by mixing predetermined pigments according to the respective pixels 301a is used.

In the liquid crystal element E31 on the active matrix substrate 301A, various materials such as esters, biphenyls, phenylcyclohexanes, cyclohexanes, phenylpyrimidines, and dioxanes can be used for a base material of the liquid crystal layer 312. The liquid crystal layer 312 is formed by mixing the aforementioned base material with materials according to purposes.

An oxide conductive material such as ZTO or ITO can be used for the pixel electrode 311. The present embodiment describes a case of using a transparent conductive film made of ZTO. In addition, an oxide conductive material such as ZTO or ITO can be used for the common electrode 313 like the pixel electrode 311. The present embodiment describes an example of using a transparent conductive film made of ZTO.

The alignment film 314 and 315 are for aligning the molecular arrangement of the liquid crystal layer 312 in a fixed direction and appropriately made of a material such as polyimide according to the material used for the liquid crystal layer 312.

The dielectric projection 316 controls the arrangement direction of liquid crystal molecules when a bias voltage is applied to the liquid crystal layer 312, and is provided in a protruded manner from the top surface of the liquid crystal layer 312 toward its inner side so as to oppose the central portion of the pixel electrode 311 with the liquid crystal layer 312 interposed therebetween. The dielectric projection 316 can be formed by using a dielectric material such as a photosensitive resin.

The light shielding film 321 can be formed of a metal film such as chromium (Cr) or a photosensitive resist film such as a black resist in which a light shielding dispersion pigment typified by carbon black is dispersed. The present embodiment describes a case of forming the film 321 by using Cr.

A spacer 317 secures a space where the liquid crystal between the active matrix substrate 301A and the opposing substrate 302A is sealed, and can be formed by using, for example, a photosensitive resin. However, the present invention is not limited thereto.

The polarizing plates 330 and 340 are filters that are vertical to a light traveling direction and transmit light that vibrates intensively in a particular direction, and can be formed by a polyvinyl alcohol (PVA) film that iodine (I) is absorbed. However, the present invention is not limited thereto.

The opposing substrate 302A is composed of, for example, a transparent substrate 320. Various transparent insulating substrates such as a glass substrate, a quartz substrate, and a plastic substrate can be used for the transparent substrate 320. A flexible substrate can be used as the transparent substrate 320.

### (Manufacturing Method)

A method for manufacturing the liquid-crystal display device 300 according to the present embodiment is described next in detail with reference to the drawings. Figs. 11-1 and 11-2, 12-1 to 12-6, and 13 are process views of a method for manufacturing the display panel 301 in the liquid-crystal display device 300 according to the present embodiment of the present invention. Figs. 11-1 and 11-2, 12-1 to 12-6, and 13 depict a continuous end facet cut at the same position as that of the line B-B' shown in Fig. 9.

First, according to this manufacturing method, the active matrix substrate 301A that comprises the switching transistor Q31 and the storage capacitor C31 is manufactured by the same steps as the steps described in the first embodiment of the present invention with reference to Figs. 5-1 to 5-7.

ZTO is then formed on the active matrix substrate 301A by, for example, sputtering method or CVD method, so that a transparent ZTO film that comprises an electrical contact to the contact plug 51 is formed. The ZTO film is then patterned by photolithography method, so that the pixel electrode 311 electrically connected to the contact plug 51 is formed on the interlayer insulating film 50 as shown in Fig. 11-1. However, the present invention is not limited thereto, and the pixel electrode 311 can be formed by a coating process technique such as a printing technique utilizing a sol gel method or an ink jet.printing technique.

Next, for example, a polyimide solution is then spin coated on the active matrix substrate 301A with the pixel electrode 311 being formed thereon and dried to solidify it. A resultant polyimide film is then rubbed by rubbing method. As shown in Fig. 11-2, the alignment film 314 that covers the pixel electrode 311 is formed on the active matrix substrate 301A. However, the present invention is not limited thereto, and the alignment film 314 can be formed by, for example, the coating process technique described above and then processed by rubbing.

Thereafter, a sealing material for preventing flow of a liquid crystal material is formed around the region on the active matrix substrate 301A where the pixels 301a are arranged. Various steps comprising a step of coating a transfer can be performed if necessary.

According to this manufacturing method, the transparent substrate 320 for the opposing substrate 302A is prepared and Cr is deposited on one of two main surfaces vertical to a thickness direction of the substrate (hereinafter, this is called top surface) by, for example, sputtering method, CVD method, or vacuum deposition method, so that a light shielding chromium film is formed. The chromium film is then patterned by photolithography method, so that the light shielding film 321 that has a light shielding property as a black matrix is formed in the region above the active matrix substrate 301A where the pixel 301a is partitioned as shown in Fig. 12-1. However, the present invention is not limited thereto, and the light shielding film 321 may be formed by using a black resist and photolithography method.

Next, a photosensitive resist liquid with which a predetermined pigment is mixed according to R, G, or B is spin coated on the opposing substrate 302A with the light shielding film 321 being formed thereon, and a step of exposing to light and developing a resultant substrate is repeated. As shown in Fig. 12-2, the color filter 64 that transmits the wavelength of an appropriate band according to the R, G, or B pixel 301a is thus formed. However, the present invention is not limited thereto, and the color filter 64 may be formed for each of the R, G, and B pixels 301a by the coating process technique described above. The light shielding film 321 is positioned under the boundary between adjacent color filters 64.

Next, ZTO is formed on the opposing substrate 302A with the color filter 64 being formed thereon by sputtering method or CVD method, so that a transparent ZTO film is formed. By removing an excessive ZTO film by photolithography method, as shown in Fig. 12-3, the common electrode 313 is formed on at least the entire region opposing to the region where pixels (301a) are arranged. However, the present invention is not limited thereto, and the common electrode 313 may be formed by the coating process technique described above.

A polyimide solution is then spin coated on the opposing substrate 302A with the common electrode 313 being formed thereon and dried to solidify it. A resultant polyimide film is then rubbed by rubbing method, so that the alignment film 315 is formed as shown in Fig. 12-4. However, the present invention is not limited thereto, and the alignment film 315 may be formed by the coating process technique described above and then be processed by rubbing method.

A photosensitive resist liquid is then spin coated on the opposing substrate 302A with the alignment film 315 being formed thereon and a resultant substrate is exposed to light and developed. Consequently, a corner of the resultant resin film is formed into the triangular shaped dielectric projection 316 on the alignment film 315 by increasing a post-bake temperature, as shown in Fig. 12-5. However, the present invention is not limited thereto, and the dielectric projection 316 of a predetermined shape may be formed by the coating process technique described above, or a pattern may be processed three dimensionally using a halftone mask by photolithography method.

A photosensitive resist liquid is then spin coated on the opposing substrate 302A with the dielectric projection 316 being formed thereon, and a resultant substrate is exposed to light and developed. As shown in Fig. 12-6, the spacer 317 made of a photosensitive resin is formed in at least a part of the region above the opposing substrate 302A where each of the pixels 301a is partitioned. However, the present invention is not limited thereto, and the spacer 317 may be formed by the coating process technique described above. Alternatively, a space where the liquid crystal layer 312 is sealed may be secured by using a method of spraying a spherical spacer.

As described above, when the active matrix substrate 301A with the pixel electrode 311 and the alignment film 314 being formed thereon and the opposing substrate 302A with the light shielding film 321, the color filter 64, the common electrode 313, the alignment film 315, the dielectric projection 316, and the spacer 317 being formed thereon are manufactured, a liquid crystal is loaded into the region on the opposing substrate 302A surrounded by the sealing material. As shown in Fig. 13, the active matrix substrate 301A is then adhered to the opposing substrate 302A, so that the liquid crystal layer 312 is sealed between the active matrix substrate 301A and the opposing substrate 302A.

Next, the polarizing plates 330 and 340 made of polyvinyl alcohol (PVA) that iodine (I) is absorbed are prepared and attached to the active matrix substrate 301A and the opposing substrate 302A, respectively so as to sandwich the liquid crystal layer 312. The display panel 301 that comprises the pixel 301a with the layer structure shown in Fig. 10 is thus manufactured.

Thereafter, the display panel 301 manufactured by the manner described above is mounted to the housing in which the signal control unit 102, the scan driving unit 103, the data driving unit 104, the capacitance-line driving unit 305, and other components are incorporated, so that the liquid-crystal display device 300 according to the present embodiment is manufactured.

While the manufacturing step described above comprises a step of washing a substrate and the like as appropriate, these steps will be omitted to simplify the descriptions.

As described above, according to the liquid-crystal display device 300 of the present embodiment, as in the first or third embodiment of the present invention, at least a part of the main wiring has a larger conductivity than that of other wirings. Therefore, the cross-sectional area (particularly the width) of the main wiring can be reduced, and thus the ratio of the main wiring to the light outputting surface of the active matrix substrate 301A can be reduced. Consequently, the aperture ratio of the active matrix substrate 301A can be improved. In addition, because the main wiring is formed of the first metal wiring 41M with a high conductivity, the resistance of the main wiring can be reduced and the drive voltage of the active matrix substrate 301A can be also reduced. As a result, the consumption power of the liquid-crystal display device 300 can be reduced.

Because the aperture ratio is improved, the flexibility in the arrangement of the liquid crystal element E31 and the light source 350 is also improved. The liquid-crystal display device 300 with greater flexibility in design can be realized.

Further, according to the manufacturing method of the present embodiment, the contact hole wiring 42 and the second wiring layer 43 are covered by the transparent semiconductor layer 44 in the manufacturing process as in the first or second embodiment of the present invention. Process damages subjected to the wiring (such as 42 and 43) at a subsequent etching step can thus be reduced.

The above embodiments are only examples for carrying out the present invention and the present invention is not limited to these embodiments. Various modifications made according to specifications and the like are within the scope of the invention, and it is obvious from the above descriptions that various other embodiments can be made within the scope of the present invention.

### EXPLANATIONS OF LETTERS OR NUMERALS

10, 320 transparent substrate
11, 21, 15 gate electrode
12, 22, 16 gate insulating film
13, 23, 17 transparent semiconductor layer
14d, 18d, 24d drain electrode
14s, 18s, 24s source electrode
31, 35 lower electrode
32, 36 capacitive insulating film
33, 37 upper electrode
40, 50 interlayer insulating film
41 transparent wiring
41a redundant wiring
41M first metal wiring
42 contact hole wiring
42M contact hole metal wiring
43 second wiring layer
43M second metal layer
44 transparent semiconductor layer
51 contact plug
61 anode electrode
62 organic film
63, 65 cathode electrode
64 color filter
66 auxiliary electrode
70 partition wall
80 passivation film
100 organic EL display device
100a bottom surface
101, 301 display panel
101A, 301A active matrix substrate
101a, 201a, 301a pixel
200a, 300a top surface
300 liquid-crystal display device
302A opposing substrate
311 pixel electrode
312 liquid crystal layer
313 common electrode
314, 315 alignment film
316 dielectric projection
317 spacer
321 light shielding film
330, 340 polarizing plate
C1 capacitor
C31 storage capacitor
D1, D2 organic-light emitting diode
E31 liquid crystal element
L_{D} data line
L_{G} scanning line
L_{P} drive line
L_{C} capacitance line
L1, L2, L31 wiring
Q1, Q31 switching transistor
Q2 driving transistor
RC three-dimensional wiring

## Claims

1. An active matrix substrate having a plurality of transistor elements, the active matrix substrate comprising:
a substrate that can transmit visible light;
a wiring that comprises a main wiring formed on the substrate and a sub-wiring that is formed on the substrate and connects the main wiring to the transistor element;
a semiconductor layer that overlaps at least a part of the wiring in a thickness direction of the substrate and can transmit visible light; and
an insulating film that covers at least a part of the wiring and of the semiconductor layer and can transmit visible light, wherein
the sub-wiring is made of a conductive material that can transmit visible light, and
the main wiring is made of a conductive material at least a part of which has a higher conductivity than that of the sub-wiring.

2. The active matrix substrate according to claim 1, wherein the semiconductor layer is made of a semiconductor material whose main ingredient is same as a main ingredient of a conductive material of the sub-wiring.

3. The active matrix substrate according to claim 1, wherein a main ingredient of a conductive material for the sub-wiring and a semiconductor material for the semiconductor layer is an inorganic oxide.

4. The active matrix substrate according to claim 1, wherein
the sub-wiring is made of a conductive material made of zinc tin oxide, and
the semiconductor layer is made of a semiconductor material whose carrier density is lower than that of the sub-wiring and that is made of zinc tin oxide.

5. The active matrix substrate according to claim 1, wherein at least a part of the main wiring is made of metal or alloy.

6. The active matrix substrate according to claim 1, wherein a part of the sub-wiring functions as an electrode in the transistor element.

7. The active matrix substrate according to claim 1, wherein a part of the sub-wiring functions as a gate electrode, a source electrode, and a drain electrode in the transistor element, and a part of the insulating film functions as a gate insulating film in the transistor element.

8. The active matrix substrate according to claim 1, comprising a first transistor, a second transistor, and a capacitor, wherein
the main wiring constitutes at least a part of one or more scanning lines, at least a part of one or more data lines, and at least a part of one or more drive lines,
a control terminal of the first transistor is connected to the scanning line and an input terminal thereof is connected to the data line,
a control terminal of the second transistor is connected to an output terminal of the first transistor and an input terminal of the second transistor is connected to the drive line, and
one electrode of the capacitor is connected to the drive line and the other terminal of the capacitor is connected to the control terminal of the second transistor.

9. The active matrix substrate according to claim 1, comprising a first transistor and a capacitor, wherein
the main wiring constitutes at least a part of one or more scanning lines, at least a part of one or more data lines, and at least a part of one or more capacitance lines,
a control terminal of the first transistor is connected to the scanning line and an input terminal of the first transistor is connected to the data line, and
one terminal of the capacitor is connected to an output terminal of the transistor.

10. A display panel comprising:
the active matrix substrate according to claim 1;
a first electrode that is formed on the active matrix substrate and can transmit visible light;
an organic film formed on the first electrode; and
a second electrode formed on the organic film.

11. The display panel according to claim 10, wherein the second electrode can transmit visible light.

12. The display panel according to claim 11, comprising an auxiliary electrode that is electrically connected to the second electrode.

13. The display panel according to claim 12, wherein the auxiliary electrode can transmit visible light.

14. The display panel according to claim 10, comprising a filter film that is formed on one or both of an upper layer and a lower layer with respect to the organic film.

15. A display panel comprising:
the active matrix substrate according to claim 1;
an opposing substrate that can transmit visible light; and
a liquid crystal element that comprises a liquid crystal layer, two alignment films that sandwich the liquid crystal layer, and a pixel electrode and a common electrode that sandwich a laminated body comprising the liquid crystal layer and the two alignment films, wherein
the pixel electrode and the common electrode can transmit visible light,
the pixel electrode is electrically connected to the wiring in the active matrix substrate, and
the liquid crystal element is sandwiched between the active matrix substrate and the opposing substrate.

16. The display panel according to claim 15, comprising two polarizing plates that sandwich a laminated body that comprises the active matrix substrate, the liquid crystal element, and the opposing substrate.

17. The display panel according to claim 15, comprising:
a light shielding film that is formed on the common electrode; and
a filter film that is formed at least on the common electrode and transmits a wavelength of a predetermined band.

18. A display device comprising the display panel according to claim 10.

19. A method for manufacturing an active matrix substrate comprising:
forming, on the substrate, a main wiring that can transmit visible light;
forming, on the substrate, a first sub-wiring that is electrically connected to the main wiring, a part of which comprises an electrode that forms a transistor element, and that can transmit visible light;
forming, on the substrate, a first insulating film that covers at least a part of the main wiring and of the first sub-wiring, a part of which comprises an insulating film that forms the transistor element, and that can transmit visible light;
forming, on the first insulating film, a second sub-wiring a part of which comprises an electrode that forms the transistor element and that can transmit visible light;
forming, on the first insulating film, a semiconductor layer that covers at least a part of the second sub-wiring and can transmit visible light; and
forming, on the first insulating film, a second insulating film that covers at least a part of the semiconductor layer and of the second sub-wiring and can transmit visible light, wherein
at least a part of the main wiring is made of a material with a higher conductivity than that of the first and/or second sub-wiring.

20. The method for manufacturing an active matrix substrate according to claim 19, wherein the semiconductor layer is formed by using a semiconductor material whose main ingredient is same as that of the second sub-wiring.

21. The method for manufacturing an active matrix substrate according to claim 19, wherein a main ingredient of a conductive material for the second sub-wiring and a semiconductor material for the semiconductor layer is an inorganic oxide.

22. The method for manufacturing an active matrix substrate according to claim 19, wherein
the second sub-wiring is formed by using a conductive material made of zinc tin oxide, and
the semiconductor layer is formed by using a semiconductor material made of zinc tin oxide whose carrier density can be lower than that of the second sub-wiring.

23. The method for manufacturing an active matrix substrate according to claim 19, wherein at least a part of the main wiring is formed by using metal or alloy.

24. The method for manufacturing an active matrix substrate according to claim 19, wherein at the step of forming the semiconductor layer, a semiconductor film that covers the second sub-wiring is formed on the first insulating film and etched such that the second sub-wiring is not exposed, so that the semiconductor layer is formed.

25. The method for manufacturing an active matrix substrate according to claim 19, wherein at at least one of the step of forming the first wiring, forming the first insulating film, forming the second wiring, forming the semiconductor layer, and forming the second insulating film, the main wiring, the first sub-wiring, the first insulating film, the second sub-wiring, the semiconductor layer, or the second insulating film is formed by printing method or ink jet printing method.
